(19) Europäisches Patentamt
European Patent Office
Office européen des brevets

(11) **EP 2 884 662 B1**

(12) **EUROPÄISCHE PATENTSCHRIFT**

(45) Veröffentlichungstag und Bekanntmachung des Hinweises auf die Patenterteilung:
**26.06.2019 Patentblatt 2019/26**

(51) Int Cl.:
***H03K 17/082*** *(2006.01)*

(21) Anmeldenummer: **13197267.1**

(22) Anmeldetag: **13.12.2013**

(54) **Vorrichtung und Verfahren zur Detektion eines Kurzschluss- oder Überstromzustands in einem Leistungshalbleiterschalter**

Device and method for detecting a short-circuit or excess current condition in a semiconductor power switch

Dispositifs et procédé de détection d'un état de court-circuit ou de surtension dans un commutateur de puissance à semi-conducteurs

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**17.06.2015 Patentblatt 2015/25**

(73) Patentinhaber: **Power Integrations Switzerland GmbH**
**2504 Biel-Bienne (CH)**

(72) Erfinder: **Rätz, Markus**
**3297 Leuzigen (CH)**

(74) Vertreter: **Conroy, John et al**
**Fish & Richardson P.C.**
**Highlight Business Towers**
**Mies-van-der-Rohe-Straße 8**
**80807 München (DE)**

(56) Entgegenhaltungen:
**EP-A1- 2 501 042       US-A1- 2012 200 320**
**US-A1- 2012 218 669**

- **Jan Thalheim ET AL: "Universal Chipset for IGBT and Power-MOSFET Gate Drivers", , 24. Mai 2007 (2007-05-24), Seiten 1-6, XP055115918, Nuremburg Gefunden im Internet: URL:ftp://ftp.efo.ru/pub/efo-ftp/TMP/pub/power/drivers/Technical%20Papers/PCIM2007_Universal_Chipset.pdf [gefunden am 2014-04-30]**
- **Heinz Rüedi ET AL: "Driver Solutions for High-voltage IGBTs", , 30. April 2002 (2002-04-30), Seiten 1-11, XP055115881, Gefunden im Internet: URL:ftp://efo.ru/pub/efo-ftp/TMP/pub/power/drivers/Technical%20Papers/PCIM_Europe_2002-3_High_Voltage_Driver_Solutions.pdf [gefunden am 2014-04-29]**

EP 2 884 662 B1

**Beschreibung**

**Technisches Gebiet**

Die vorliegende Erfindung betrifft eine Vorrichtung zur Detektion eines Verlaufs einer Spannung, die über einem Leistungshalbleiterschalter abfällt. Derartige Vorrichtungen werden beispielsweise zum Detektieren eines Kurzschluss- oder Überstromzustands in einem IGBT ("Insulated Gate Bipolar Transistor") verwendet.

**Hintergrund**

In manchen Leistungshalbleiterschaltern können hohe Spannungen angelegt und hohe Ströme geführt werden. Kurzschlüsse oder überhöhte Ströme können daher schnell zur thermischen Zerstörung der Leistungshalbleiterschalter führen. Leistungshalbleiterschalter können Schutzschaltungen zur Detektion eines Kurzschluss- oder Überstromzustands aufweisen. Eine Möglichkeit, diese Zustände zu detektieren, ist die indirekte Überwachung des Stroms durch den Leistungshalbleiterschalter anhand einer über dem Leistungshalbleiterschalter abfallenden Spannung. Die Spannung über dem Leistungshalbleiterschalter sollte nach Einschalten des Leistungshalbleiterschalters zügig von einem relativ hohen Pegel im ausgeschalteten Zustand (der "ausgeschaltete Zustand" oder "AUS-Zustand" ist ein Zustand des Leistungshalbleiterschalter, in dem dieser "offen" ist und keinen Strom führt) auf einen relativ niedrigen Pegel im angeschalteten Zustand fallen (der "angeschaltete Zustand" oder "AN-Zustand" ist ein Zustand des Leistungshalbleiterschalter, in dem dieser "geschlossen" ist und Strom führen kann). Entsprechend hat ein Steuersignal eines Leistungshalbleiterschalters (zum Beispiel ein Gate-Treibersignal) einen AN-Zustand, in dem es den Leistungshalbleiterschalter geschlossen hält und einen AUS-Zustand, in dem es den Leistungshalbleiterschalter offen hält.

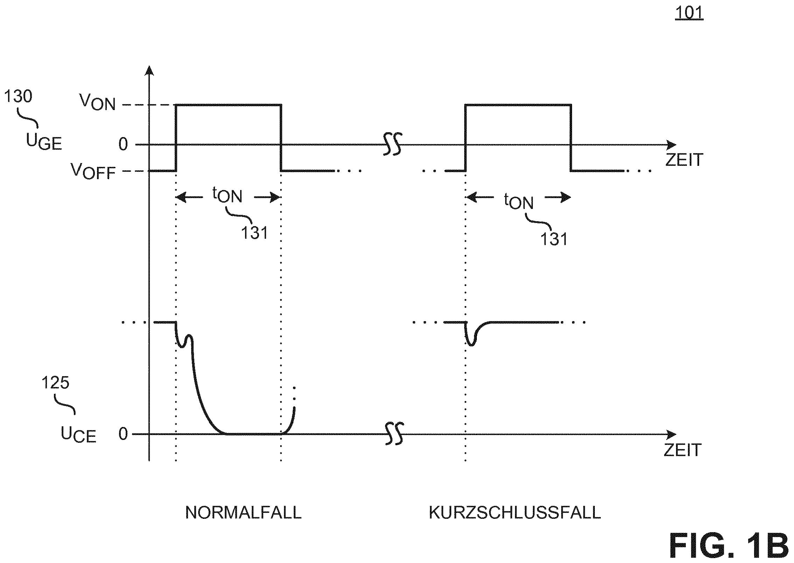

Die Kurve links unten in Fig. 1B zeigt einen beispielhaften Verlauf einer Kollektor-Emitter-Spannung eines IGBT (ein IGBT ist ein beispielhafter Leistungshalbleiterschalter) nach dem Umschalten von einem ausgeschalteten Zustand in einen angeschalteten Zustand im Normalbetrieb (der Verlauf eines zugehörigen beispielhaften Steuersignal ist links oben dargestellt). Wie dargestellt, fällt die Kollektor-Emitter-Spannung stark auf einen sehr geringen Wert ab (zum Beispiel zwischen 0 und 10 V). Ein beispielhaftes Kurzschlussverhalten eines IGBT ist rechts unten in Fig. 1B gezeigt. Im Gegensatz zum Normalbetrieb fällt die Kollektor-Emitter-Spannung nicht auf den sehr geringen Wert ab, gleichzeitig können aber in dem IGBT hohe Ströme fließen (zum Beispiel zwischen dem dreifachen und zehnfachen Nennstrom des IGBT). In anderen Kurzschlussfällen sinkt die Kollektor-Emitter-Spannung zwar zunächst auf den Wert im Normalbetrieb ab, steigt aber dann wieder an. Daraus kann eine hohe thermische Belastung des Leistungshalbleiterschalters resultieren, der nach relativ kurzer Zeit Schaden nehmen kann. So können zum Beispiel einige IGBTs im angeschalteten Zustand einen Kurzschluss lediglich für kurze Zeit (zum Beispiel für etwa 10 µs) überstehen, ohne Schaden zu nehmen. Schutzschaltungen zur Detektion eines Kurzschluss- oder Überstromzustands können vor Ablauf dieser Zeit dafür sorgen, dass der Leistungshalbleiterschalter abgeschaltet wird. Ähnliche Charakteristiken sind auch in anderen Leistungshalbleiterschalter außer IGBTs zu finden. Ein Überstromzustand kann sich wie ein Kurzschlusszustand durch eine erhöhte Kollektor-Emitter-Spannung zeigen. Allerdings kann im Überstromfall die Kollektor-Emitter-Spannung näher an einer Kollektor-Emitter-Spannung im Normalfall liegen als im Kurzschlussfall.

Auch kann ein einige Zeit nach dem Anschalten des Leistungshalbleiterschalters auftretender Kurzschluss- oder Überstromzustand dazu führen (nicht in Fig. 1B gezeigt). In diesem Fehlerfall sinkt die Kollektor-Emitter-Spannung zunächst auf den niedrigen Wert des Normalbetriebs ab, bevor ein Fehler auftritt, der zum Beispiel zu einem Kurzschluss führt. Dann steigt die Kollektor-Emitter-Spannung stark an. Das kann ebenfalls die oben beschriebenen negativen Auswirkungen auf den Leistungshalbleiterschalter haben.

Die geschilderten Unterschiede im Verlauf der Kollektor-Emitter-Spannung zwischen Normalbetrieb und Kurzschluss- und/oder Überstromfall können in Schutzschaltungen zur Detektion eines Kurzschluss- oder Überstromzustands ausgenutzt werden, um einen Kurzschluss- oder Überstromzustand zu detektieren.

Die Europäische Patentanmeldung EP 2 501 042 A1 offenbart eine Detektionsschaltung welche $V_{CE}$-Monitoring mittels eines kompensierten Spannungsteilers ermöglicht.

**Zusammenfassung der Erfindung**

Die vorliegende Erfindung betrifft eine erste Vorrichtung zur Detektion eines Verlaufs einer Spannung über einem Leistungshalbleiterschalter gemäß Anspruch 1. Weitere Ausführungsformen sind in den abhängigen Ansprüchen beschrieben.

Die "Spannung über einem Leistungshalbleiterschalterschalter" bezieht sich auf die Spannung zwischen den Anschlüssen des Leistungshalbleiterschalters, zwischen denen im Normalbetrieb der Hauptteil der über den Leistungshalbleiterschalter fließenden elektrischen Energie transportiert wird. Die entsprechenden Anschlüsse werden für verschiedene Leistungshalbleiterschalter unterschiedlich bezeichnet (zum Beispiel Kollektor und Emitter, Drain und Source oder Kathode und Anode).

Ein "Signal, das für die Spannung über dem Leistungshalbleiterschalter repräsentativ ist" hat einen ersten charakteristischen Verlauf, wenn die Spannung über dem Leistungshalbleiterschalter (zum Beispiel die Kollektor-Emitter-Spannung oder die Drain-Source-Spannung) stark auf einen sehr geringen Wert (nahe bei 0 Volt, zum Beispiel zwischen 0 und 10 V) abfällt, nachdem der Leistungshalbleiterschalter angeschaltet wird, und einen zweiten, unterschiedlichen charakteristischen Verlauf, wenn die Spannung über dem Leistungshalbleiterschalter nicht auf einen sehr geringen Wert (nahe bei 0 Volt) abfällt, nachdem der Leistungshalbleiterschalter angeschaltet wird. Zudem kann das "Signal, das für die Spannung über dem Leistungshalbleiterschalter repräsentativ ist" einen weiteren unterschiedlichen charakteristischen Verlauf haben, wenn die Spannung über dem Leistungshalbleiterschalter im angeschalteten Zustand von einem sehr geringen Wert (nahe bei 0 Volt) einige Zeit nach dem Anschalten des Leistungshalbleiterschalters stark ansteigt.

Ein "resistiv-kapazitives Netzwerk" beinhaltet Elemente, die sich zumindest in den Betriebsbereichen, für die die Vorrichtung zur Detektion eines Verlaufs einer Spannung über einem Leistungshalbleiterschalter ausgelegt ist, resistiv (Spannung und Strom über dem Element sind in Phase) beziehungsweise kapazitiv (der Strom eilt der Spannung voraus) verhalten. Somit können die Elemente des resistiv-kapazitiven Netzwerks durchaus in anderen Betriebsbereichen oder Schaltungen andere Eigenschaften haben. Ein "resitives Element" kann sowohl ein ohmsches Element als auch ein Element mit einer nichtlinearen Strom-Spannungs-Kurve sein.

Der Einsatz einer Vorrichtung zur Detektion eines Verlaufs einer Spannung über einem Leistungshalbleiterschalter trägt dazu bei, einen Kurzschluss- und/oder Überstromzustand in einem Leistungshalbleiterschalter zu detektieren. Insbesondere kann die Wahrscheinlichkeit der fälschlichen Detektion eines Kurzschluss- und/oder Überstromzustand verringert werden. Das kann unter anderem erreicht werden, indem das resistiv-kapazitive Netzwerk die parasitären Kapazitäten der Vorrichtung kompensiert oder überkompensiert. So kann verhindert werden, dass diese eine Zeitgeberschaltung beeinflussen (zum Beispiel eine Kapazität der Zeitgeberschaltung, die das Detektionssignal liefert), nachdem die Spannung über dem Leistungshalbleiterschalter bereits auf einen sehr geringen Pegel abgefallen ist (also im Normalfall, siehe **Fig. 1B** links) und so eine fälschliche Detektion eines Kurzschluss- oder Überstromzustands erfolgt.

Die erste Vorrichtung umfasst weiter eine erste Klemmschaltung, die dazu ausgelegt ist, eine Spannung am dritten Knoten des resistiv-kapazitiven Netzwerks auf eine vorbestimmte Maximalspannung zu begrenzen.

In einer zweiten Vorrichtung gemäß der ersten Vorrichtung entspricht die vorbestimmte Maximalspannung einem AN-Pegel eines Gate-Treibersignals des Leistungshalbleiterschalters.

In einer dritten Vorrichtung gemäß einer der ersten bis zweiten Vorrichtungen werden die parasitären Kapazitäten der Vorrichtung zur Detektion eines Verlaufs einer Spannung über den Leistungshalbleiterschalter durch die mindestens eine Impedanz kompensiert oder überkompensiert.

In einer vierten Vorrichtung gemäß einer der ersten bis dritten Vorrichtungen umfasst die mindestens eine Impedanz ein kapazitives und ein dazu paralleles resistives Element.

In einer fünften Vorrichtung gemäß der vierten Vorrichtung umfasst das resistiv-kapazitive Netzwerk eine oder mehr weitere Impedanzen, die in Serie mit der mindestens einen Impedanz zwischen dem ersten Knoten und dem zweiten Knoten des resistiv-kapazitiven Netzwerks gekoppelt sind, wobei jede der ein oder mehr weiteren Impedanzen ein kapazitives und ein dazu paralleles resistives Element umfassen.

In einer sechsten Vorrichtung gemäß einer der ersten bis fünften Vorrichtungen enthält die Vorrichtung weiter eine zweite Klemmschaltung, die dazu ausgelegt ist, den dritten Knoten auf eine vorbestimmte Minimalspannung zu begrenzen.

In einer siebten Vorrichtung gemäß der sechsten Vorrichtung entspricht die vorbestimmte Minimalspannung einem AUS-Pegel eines Gate-Treibersignals des Leistungshalbleiterschalters.

In einer achten Vorrichtung gemäß einer der ersten bis siebten Vorrichtungen beinhaltet die Zeitgeberschaltung eine Kapazität, die in Reaktion auf den Spannungspegel an dem dritten Knoten des resistiv-kapazitiven Netzwerks geladen oder entladen wird und wobei ein Spannungspegel an einem Ende der Kapazität der Zeitgeberschaltung das Detektionssignal ist.

In einer neunten Vorrichtung gemäß der achten Vorrichtung umfasst die Zeitgeberschaltung weiter ein resistives Element und das resistive Element ist zwischen einen Ausgang zur Ausgabe des Detektionssignals und den dritten Knoten des resistiv-kapazitiven Netzwerks gekoppelt.

In einer zehnten Vorrichtung gemäß einer der ersten bis neunten Vorrichtungen enthält die Zeitgeberschaltung keine aktiven Komponenten.

In einer elften Vorrichtung gemäß einer der ersten bis zehnten Vorrichtungen umfasst das resistiv-kapazitive Netzwerk ein weiteres kapazitives Element, das zwischen den zweiten Knoten und das erste kapazitive Element gekoppelt ist, wobei die mindestens eine Impedanz ein kapazitives und ein paralleles resistives Element umfasst und wobei das resistive Element an den zweiten Knoten gekoppelt ist und das kapazitive Element der mindestens einen Impedanz an das erste kapazitive Element gekoppelt ist.

In einer zwölften Vorrichtung gemäß der elften Vorrichtung hat das erste kapazitive Element einen mindestens fünfmal größeren Wert als das weitere kapazitive Element.

In einer dreizehnten Vorrichtung gemäß der ersten und der elften oder zwölften Vorrichtung ist das weitere kapazitive Element so angeordnet, dass es einen Einfluss des ersten kapazitiven Elements auf einen Spannungspegel am zweiten Knoten reduziert, wenn das Signal, das für die Spannung über dem Leistungshalbleiterschalter repräsentativ ist zwischen der vorbestimmten Maximalspannung und der vorbestimmten Schwellspannung liegt.

In einer vierzehnten Vorrichtung gemäß den elften bis dreizehnten Vorrichtungen ist das weitere kapazitive Element dazu ausgelegt, die Menge an elektrischer Ladung, die zwischen dem ersten kapazitiven Element und dem zweiten Knoten schwingt, zu reduzieren.

In einer fünfzehnten Vorrichtung gemäß der fünften oder der fünften und einer der vorangehenden Vorrichtungen umfasst das resistiv-kapazitive Netzwerk ein erstes weiteres resistives Element, das parallel zu dem ersten kapazitiven Element geschaltet ist und ein weiteres resistives Element, das parallel zu einem zweiten kapazitiven Element der mindestens einen Impedanz oder der einen oder mehr weiteren Impedanzen des resistiv-kapazitive Netzwerks geschaltet ist.

In einer sechszehnten Vorrichtung gemäß der fünfzehnten Vorrichtung sind das erste und zweite weitere resistive Element dazu ausgelegt, eine stationäre Spannung über dem ersten und zweiten kapazitiven Element zu begrenzen. In einer siebzehnten Vorrichtung gemäß einer der vorangehenden Vorrichtungen umfasst die Vorrichtung ein weiteres resistives Element, das zwischen den dritten Knoten und ein Referenzpotential gekoppelt ist und dazu ausgelegt ist, einen stationären Pegel des Detektionssignals mindestens teilweise einzustellen. In einer achzehnten Vorrichtung gemäß einer der vorangehenden Vorrichtungen umfasst die Zeitgeberschaltung ein zweites weiteres resistives Element, eine zweite Kapazität und eine Diode, die dazu ausgelegt sind, einen dynamischen Pegel des Detektionssignals zu beeinflussen.

Ein erste Vorrichtung zur Detektion eines Kurzschluss- oder Überstromzustands in einem Leistungshalbleiterschalter umfasst eine Vorrichtung zur Detektion eines Verlaufs einer Spannung über einem Leistungshalbleiterschalter gemäß einem der Vorrichtungen 1 bis 19 und einen Komparator, der das Detektionssignal der Vorrichtung zur Detektion eines einer Spannung über einem Leistungshalbleiterschalter und ein Referenzsignal empfängt und einen Fehlersignal ausgibt, das anzeigt, wenn das Detektionssignal das Referenzsignal übersteigt.

In einer zweiten Vorrichtung zur Detektion eines Kurzschluss- oder Überstromzustands gemäß der ersten Vorrichtung zur Detektion eines Kurzschluss- oder Überstromzustands ist das Referenzsignal stationär.

Eine dritte Vorrichtung zur Detektion eines Kurzschluss- oder Überstromzustands gemäß der ersten oder zweiten Vorrichtung zur Detektion eines Kurzschluss- oder Überstromzustands und der zehnten Vorrichtung umfasst weiter einen Schalter, der dazu ausgelegt ist, ein Ende der Kapazität der Zeitgeberschaltung auf ein festes Potential zu legen, wenn der Leistungshalbleiterschalter ausgeschaltet ist.

In einer vierten Vorrichtung zur Detektion eines Kurzschluss- oder Überstromzustands gemäß der dritten Vorrichtung zur Detektion eines Kurzschluss- oder Überstromzustands entlädt sich die Kapazität der Zeitgeberschaltung zumindest teilweise, wenn das Ende der Kapazität der Zeitgeberschaltung auf das feste Potential gelegt wird, wenn der Leistungshalbleiterschalter ausgeschaltet ist.

Eine erste Steuerschaltung für einen Leistungshalbleiterschalter umfasst eine Vorrichtung zur Detektion eines Kurzschluss- oder Überstromzustands in einem Leistungshalbleiterschalters gemäß einer der ersten bis vierten Vorrichtungen und eine Treiberschaltung, die das Fehlersignal empfängt und einen Leistungshalbleiterschalter ausschaltet oder ein weiteres Fehlersignal für eine Systemsteuerung bereitstellt, falls das Detektionssignal das Referenzsignal übersteigt.

Eine zweite Steuerschaltung Vorrichtung umfasst einen Leistungshalbleiterschalter, der von der Steuerschaltung gesteuert wird.

In einer weiteren Vorrichtung gemäß einem der vorangehenden Vorrichtungen entspricht die Spannung über dem Leistungshalbleiterschalter einer Kollektor-Emitter-, Anoden-Kathoden- oder Drain-Source-Spannung.

In einer weiteren Vorrichtung gemäß einem der vorangehenden Vorrichtungen beträgt ein Maximum der Nennspannung über dem Leistungshalbleiterschalter im ausgeschalteten Zustand mehr als 500 V, bevorzugt mehr als 2 kV.

## Kurzbeschreibung der Figuren

Nicht-limitierende und nicht-erschöpfende Ausführungsbeispiele der Erfindung sind bezugnehmend auf die folgenden Figuren beschrieben, wobei gleiche Referenzzeichen sich auf gleiche Komponenten in den verschiedenen Figuren beziehen, soweit nichts Anderes spezifiziert ist.

Fig. 1A zeigt eine beispielhafte Vorrichtung zur Bereitstellung von elektrischer Energie.

**Fig. 1B** zeigt verschiedene Signale der Vorrichtung aus Fig. 1A in einem Normalzustand und in einem beispielhaften Kurzschluss- und/oder Überstromzustand.

**Fig. 2** stellt eine beispielhafte Steuerschaltung dar.

**Fig. 3** zeigt eine weitere beispielhafte Vorrichtung zur Detektion eines Verlaufs einer Spannung über einem Leistungshalbleiterschalter.

**Fig. 4** zeigt eine weitere beispielhafte Vorrichtung zur Detektion eines Verlaufs einer Spannung über einem Leistungshalbleiterschalter.

**Fig. 5** zeigt verschiedene Signale in der Vorrichtung zur Detektion eines Verlaufs einer Spannung über einem Leistungshalbleiterschalter aus **Fig. 4.**

**Fig. 6** zeigt eine weitere beispielhafte Vorrichtung zur Detektion eines Verlaufs einer Spannung über einem Leistungshalbleiterschalter.

**Fig. 7** zeigt eine weitere beispielhafte Vorrichtung zur Detektion eines Verlaufs einer Spannung über einem Leistungshalbleiterschalter.

**Ausführliche Beschreibung**

In der folgenden Beschreibung werden zahlreiche Details aufgeführt, um ein tiefgreifendes Verständnis der vorliegenden Erfindung zu ermöglichen. Es ist dem Fachmann jedoch klar, dass die spezifischen Details nicht notwendig sind, um die vorliegende Erfindung umzusetzen. An anderer Stelle sind bekannte Vorrichtungen und Verfahren nicht detailliert geschildert, um das Verständnis der vorliegenden Erfindung nicht unnötig zu erschweren.

In der vorliegenden Beschreibung bedeutet eine Bezugnahme auf "eine Ausführung", "einer Ausgestaltung", "ein Beispiel" oder "Beispiel", dass ein bestimmtes Merkmal, eine Struktur oder Eigenschaft, die in Verbindung mit dieser Ausführungsform beschrieben ist, in mindestens einer Ausführungsform der vorliegenden Erfindung beinhaltet ist. So beziehen sich die Phrasen "in einer Ausführung", "in einer Ausführungsform", "ein Beispiel" oder "in einem Beispiel" an verschiedenen Stellen in dieser Beschreibung nicht unbedingt alle auf dieselbe Ausführungsform oder dasselbe Beispiel. Ferner können die bestimmten Merkmale, Strukturen oder Eigenschaften in beliebigen geeigneten Kombinationen und / oder Unterkombinationen in einer oder mehreren Ausführungsformen oder Beispielen kombiniert werden. Besonderen Merkmale, Strukturen oder Eigenschaften können in einer integrierten Schaltung, in einer elektronischen Schaltung, in einer Schaltungslogik oder in anderen geeigneten Komponenten beinhaltet sein, die die beschriebene Funktionalität bereitstellen. Darüber hinaus wird darauf hingewiesen, dass die Zeichnungen zum Zwecke der Erläuterung für den Fachmann dienen und dass die Zeichnungen nicht notwendigerweise maßstabsgetreu gezeichnet sind.

Wie in **Fig. 1B** gezeigt und weiter oben bereits beschrieben, sinkt im Normalzustand die Kollektor-Emitter-Spannung 125 ($U_{CE}$) eines Leistungshalbleiters nach Anschalten des Leistungshalbleiterschalters zügig von einem relativ hohen Pegel auf einen niedrigen Pegel ab (und verbleibt dann auf diesem Pegel). In bestimmten Kurzschluss- oder Überstromfällen dagegen fällt die Kollektor-Emitter-Spannung 125 ($U_{CE}$) nach dem Anschalten nicht stark ab, sondern verbleibt auf einem höheren Niveau. Dieses Verhalten kann in Schutzschaltungen ausgenutzt werden, um anhand des Verlaufs der Kollektor-Emitter-Spannung auf das mögliche Vorliegen eines Kurzschluss- oder Überstromzustands Rückschlüsse zu ziehen und den Leistungshalbleiterschalter gegebenenfalls abzuschalten. Wie ebenfalls bereits beschrieben, können parasitäre Kapazitäten in Vorrichtungen zur Detektion eines Verlaufs einer Kollektor-Emitter-, Anoden-Kathoden- oder Drain-Source-Spannung eines Leistungshalbleiterschalters eine fälschliche Detektion eines Kurzschluss- oder Überstromzustands auslösen, indem sie auch nach Abfall der Kollektor-Emitter-Spannung 125 ($U_{CE}$) auf einen niedrigen Pegel im Normalzustand durch Entladevorgänge Detektionssignale einer Schutzschaltung beeinflussen.

Zum Beispiel ist in einigen Schaltungen des Stands der Technik eine Serienschaltung von Widerständen vorgesehen, um die detektierte Kollektor-Emitter-Spannung 125 ($U_{CE}$) des Leistungshalbleiterschalters, die einige Kilovolt betragen kann, auf einen bestimmten Spannungspegel herunterzuteilen. Um die Verluste in dieser Schaltung zu begrenzen und auch aus schaltungstechnischen Gründen ist es in manchen Schaltungen wünschenswert, den Strom durch die Widerstände auf 1 mA oder weniger zu begrenzen. Dazu müssen dann Widerstände im Megaohm-Bereich verwendet werden. Da sich die Werte parasitärer Kapazitäten im Bereich von Picofarad bewegen können und diese über die Widerstände im Megaohm-Bereich entladen werden, ergibt sich eine Zeitkonstante von einigen Mikrosekunden für die Entladung der parasitären Kapazitäten. Diese Zeitkonstanten können im Bereich der für einige Leistungshalbleiterschalter wünschenswerten Kurzschluss-Abschaltzeit liegen (die gewünschte Abschalt-Zeit kann der Zeit entsprechen, die der Leistungshalleiterschalter überstehen kann, ohne Schaden zu nehmen), die sich in der Größenordnung von 10 μs bewegen kann und somit Detektionsschaltungen für einen Kurzschluss- oder Überstromzustand beeinflussen.

In einem Beispiel der Detektion eines Kurzschluss- oder Überstromzustands wird ein Signal, das für den Verlauf der Kollektor-Emitter-Spannung repräsentativ ist, mit einer Referenzspannung (die stationär oder zeitlich variabel sein kann) verglichen. Wenn das Signal, das für den Verlauf der Kollektor-Emitter-Spannung repräsentativ ist größer als die Referenzspannung ist, wird ein Fehler detektiert. Die parasitären Kapazitäten können aufgrund ihrer Entlade-Zeitkonstanten verursachen, dass das Signal, das für den Verlauf der Kollektor-Emitter-Spannung repräsentativ ist, die Referenzspannung übersteigt, obwohl kein Kurzschluss- oder Überstromzustand vorliegt. Somit kann der Entladevorgang der parasitären Kapazitäten mit der Detektion des Kurzschluss- oder Überstromzustands interferieren.

Beispielsweise kann in der Schutzschaltung eine Kapazität vorgesehen sein, die dazu ausgelegt ist, geladen zu werden, wenn die Kollektor-Emitter-Spannung 125 ($U_{CE}$) des Leistungshalbleiterschalters nach dem Einschaltvorgang über einem vorbestimmten Wert liegt. Diese Kapazität kann durch die parasitären Kapazitäten weiter geladen werden, obwohl die Kollektor-Emitter-Spannung 125 ($U_{CE}$) des Leistungshalbleiterschalters bereits unter den vorbestimmten Wert gefallen ist. Das kann zur Folge haben, dass die Schutzschaltung fälschlicherweise das Vorliegen einer hohen Kollektor-Emitter-Spannung 125 ($U_{CE}$) annimmt und einen Kurzschluss- oder Überstromfall detektiert. Diese Effekte sind besonders schwerwiegend bei hohen Kollektor-Emitter-Spannungen 125 ($U_{CE}$) im Bereich von mehreren Kilovolt (beispielsweise zwischen 2,2 kV und 4,5 kV bei einigen IGBTs) und für Bauelemente mit verhältnismäßig trägem Schaltverhalten.

In den hier besprochenen Vorrichtungen wird eine Zeitgeberschaltung in Kombination mit einem resistiv-kapazitiven Netzwerk eingesetzt, das die parasitären Kapazitäten kompensiert oder überkompensiert. Damit kann sichergestellt werden, dass der Einfluss der parasitären Kapazitäten auf die Detektion einen Kurzschluss- oder Überstromzustands reduziert oder verhindert wird. Das kann insbesondere zur Folge haben, dass fälschliche Detektionen eines Kurzschluss- oder Überstromzustands vermieden werden. Der Begriff "kompensiert" schließt hierin einen Fall ein, in dem die parasitären Kapazitäten bis zu einem bestimmten Grad unterkompensiert werden, solange ein Pegel des Detektionssignals nicht über die vorbestimmte Schwellspannung steigt, wenn das Signal, das für die Spannung über dem Leistungshalbleiterschalter repräsentativ nach Anschalten des Leistungshalbleiterschalters unter einen vorbestimmten Wert fällt (also im Normalfall). So ist es möglich, die parasitären Kapazitäten soweit unterzukompensieren, solange ein dynamischer Spannungspegel nach Anschalten des Leistungshalbleiterschalters an dem dritten Knoten bis auf den Wert der vorbestimmten Schwellspannung sinkt. Falls die Zeitgeberschaltung eine Kapazität enthält, so ist eine weitergehende Unterkompensation über diesen Punkt hinaus möglich. Die Grenze die mögliche Unterkompensation wird dann durch eine Ladung dieser Kapazität der Zeitgeberschaltung bestimmt. In anderen Beispielen können die parasitären Kapazitäten um bis zu 5% unterkompensiert werden (das heißt, ein Wert der Kapazitäten des resistiv-kapazitiven Netzwerk zwischen dem ersten und dem zweiten Knoten ist bis zu 5% grösser als für den exakt kompensierten Fall benötigt würde oder ein Wert des ersten kapazitiven Elements ist bis zu 5% kleiner als für den exakt kompensierten Fall benötigt).

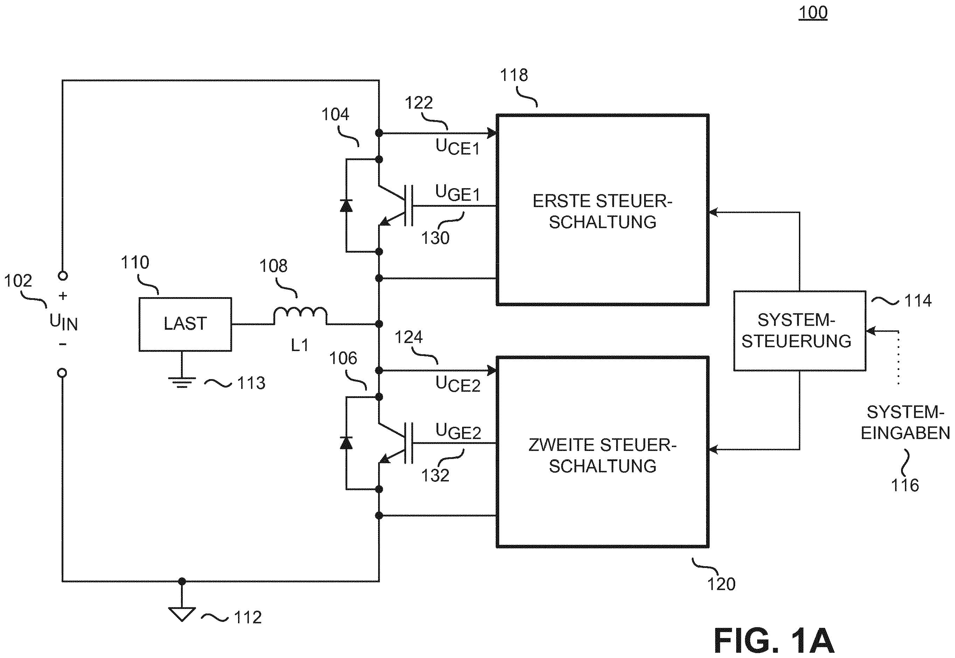

**Fig. 1A** zeigt eine Vorrichtung 100 (auch als Leistungswandler bezeichnet) zur Bereitstellung von elektrischer Energie an einen Verbraucher 110. Allerdings kann der Energiefluss auch in die andere Richtung zeigen. Dann handelt es sich bei Element 110 um einen Erzeuger. In wieder anderen Vorrichtungen kann Element 110 in verschiedenen Betriebszuständen sowohl als Verbraucher, als auch als Erzeuger arbeiten. In der Folge wird lediglich von einer Vorrichtung zur Bereitstellung von Energie gesprochen, was alle soeben besprochenen Fälle umfasst (die Energie kann an verschiedenen Ausgängen bereitgestellt werden). Die Vorrichtung umfasst zwei Leistungshalbleiterschalter 104, 106, die in Serie geschaltet sind. Zudem kann Vorrichtung 100 eine Eingangsgleichspannung 102 ($U_{IN}$) empfangen. Die Vorrichtung ist dazu ausgelegt, elektrische Energie durch Steuerung der Leistungshalbleiterschalters 104, 106 von dem Eingang an einen Ausgang zu übertragen, an den der Verbraucher 110 angeschlossen ist (oder in umgekehrte Richtung). Dabei kann die Vorrichtung zur Bereitstellung von elektrischer Energie Spannungspegel, Strompegel oder eine Kombination der beiden Größen, die an den Verbraucher abgegebenen werden, steuern. Im Beispiel von **Fig. 1A** sind die Leistungshalbleiterschalter 104, 106 IGBTs.

In der Folge werden die Vorrichtungen und Verfahren am Beispiel von IGBTs erläutert. Allerdings sind die Vorrichtungen zur Detektion eines Verlaufs einer Spannung über einem Leistungshalbleiterschalter, die Steuerschaltungen und die Vorrichtungen zur Bereitstellung von elektrischer Energie nicht auf den Einsatz mit IGBTs beschränkt. Vielmehr können sie auch in Kombination mit anderen Leistungshalbleiterschaltern verwendet werden. Zum Beispiel können MetallOxid-Halbleiter-Feldeffekttransistor (MOSFETs), Bipolartransistoren, IEGTs ("injection enhancement gate transistors") und GTOs ("gate turn-off thyristors") mit den Vorrichtungen zur Detektion eines Verlaufs einer Spannung über einem Leistungshalbleiterschalter, den Steuerschaltungen und den Vorrichtungen zur Bereitstellung von elektrischer Energie verwendet werden. Auch können die Vorrichtungen zur Detektion eines Verlaufs einer Spannung über einem Leistungshalbleiterschalter, die Steuerschaltungen und die Vorrichtungen zur Bereitstellung von elektrischer Energie mit Leistungshalbleiterschaltern verwendet werden, die auf Galliumnitrid-(GaN)-Halbleitern oder Siliziumkarbid-(SiC)-Halbleitern basieren.

Eine maximale nominale Kollektor-Emitter-, Anoden-Kathoden oder Drain-Source-Spannung eines Leistungshalbleiterschalters im ausgeschalteten Zustand kann mehr als 500 V, bevorzugt mehr als 2 kV, betragen.

Zudem sind die Vorrichtungen zur Detektion eines Verlaufs einer Spannung über einem Leistungshalbleiterschalter, die Steuerschaltungen und die Vorrichtungen zur Bereitstellung von elektrischer Energie nicht auf Leistungshalbleiterschalter beschränkt. So können auch andere Halbleiterschalter mit den Vorrichtungen zur Detektion eines Verlaufs einer Spannung über einem Leistungshalbleiterschalter, die Steuerschaltungen und die Vorrichtungen zur Bereitstellung von elektrischer Energie verwendet werden. Die Effekte und Vorteile, die hier besprochen werden, treten zumindest teilweise auch in Systemen mit anderen Halbleiterschaltern auf.

Da in der Folge IGBTs diskutiert werden, werden die Anschlüsse des Leistungshalbleiterschalters als "Kollektor", "Gate" und, "Emitter" bezeichnet. Wir bereits oben erläutert, sind die Vorrichtungen und Verfahren jedoch nicht auf IGBTs beschränkt. Um unnötige Längen zu vermeiden, umfasst die Bezeichnung "Emitter" hierin auch den mit "Source" oder "Kathode" bezeichneten Anschluss entsprechender Leistungshalbleiterschalter. Gleichermaßen umfasst der Begriff "Kollektor" hierin auch den mit "Drain" oder "Anode" bezeichneten Anschluss und der Begriff "Gate" den mit "Basis" bezeichneten Anschluss entsprechender Leistungshalbleiterschalter. In der Folge umfasst der Begriff "Kollektor-Emitter-Spannung" auch eine "Drain-Source-Spannung" und eine "Kathoden-Anoden-Spannung" und die Begriffe "Kollektor- Spannung" und "Emitter-Spannung" auch eine "Drain-Spannung" oder "Anoden-Spannung" beziehungsweise eine "Source-Spannung" oder "Kathoden-Spannung".

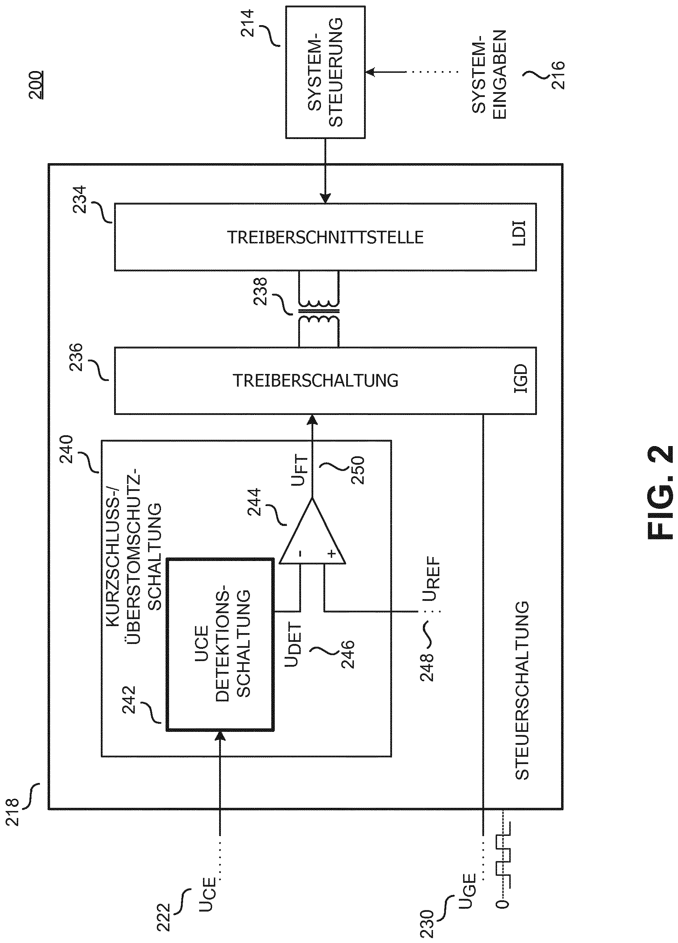

Die Leistungshalbleiterschalter 104, 106 werden jeweils von einer ersten und zweiten Steuerschaltung 118, 120 gesteuert (eine beispielhafte Steuerschaltung wird im Zusammenhang mit Fig. 2 erläutert). Diese stellen ein erstes und ein zweites Gate-Emitter-Treibersignal 130, 132 ($U_{GE1}$, $U_{GE2}$) bereit, um die Schaltzeitpunkte des ersten und zweiten IGBTs zu steuern. Beide Steuerschaltungen 118, 120 können optional wiederum von einer Systemsteuerung 114 gesteuert werden. Die Systemsteuerung 114 kann einen Eingang zum Empfangen von System-Eingabesignalen 116 aufweisen. In dem Beispiel von Fig. 1A sind zwei Leistungshalbleiterschalter 104, 106 in einer Halbbrücken-Konfiguration dargestellt. Die Vorrichtungen zur Detektion eines Verlaufs einer Spannung über einem Leistungshalbleiterschalter, die Steuerschaltungen und die Vorrichtungen zur Bereitstellung von elektrischer Energie können jedoch auch in anderen Topologien eingesetzt werden. Beispielsweise kann ein einzelner Leistungshalbleiterschalter (z.B. ein einzelner IGBT) mit einer Vorrichtung zur Detektion eines Verlaufs einer Spannung über einem Leistungshalbleiterschalter oder einer Steuerschaltung beschaltet werden. In anderen Beispielen kann in einem dreiphasigen System mit sechs Leistungshalbleiterschaltern oder zwölf Leistungshalbleiterschaltern jeder der Leistungshalbleiterschalter eine Vorrichtung zur Detektion eines Verlaufs einer Spannung über einem Leistungshalbleiterschalter aufweisen.

Neben der Ausgabe eines Gate-Emitter-Treibersignals nehmen die Steuerschaltungen 118, 120 Signale auf, die Spannungen, die über den Leistungshalbleiterschaltern 104, 106 anliegen, repräsentieren. Bei den Signalen kann es sich um Spannungssignale oder Stromsignale handeln. Im Beispiel von Fig. 1A weist jede Steuerschaltung 118, 120 jeweils ein Signal, das für die Kollektor-Emitter-Spannung repräsentativ ist und als Kollektor-Emitter-Spannungssignal 122, 124 ($U_{GE1}$, $U_{CE2}$) bezeichnet wird, auf.

In Fig. 1A sind die Steuerschaltungen 118, 120 als separate Steuerschaltungen skizziert. Allerdings können beide Steuerschaltungen 118, 120 auch in einer einzigen Schaltung kombiniert sein. In diesem Fall steuert eine einzige Steuerschaltungen zwei Leistungshalbleiterschalter 104, 106. Darüber hinaus kann das zweite Gate-Emitter-Treibersignal 132 ($U_{GE2}$) ein invertiertes erstes Gate-Emitter-Treibersignal 130 ($U_{GE1}$) sein.

Beide Steuerschaltungen 118, 120 umfassen eine Vorrichtung zur Detektion eines Verlaufs einer Spannung über einem Leistungshalbleiterschalter. Basierend auf dem jeweiligen Kollektor-Emitter-Spannungssignal 122, 124 ($U_{GE1}$, $U_{CE2}$) kann ein Kurzschluss- und/oder Überstromzustand des jeweiligen Leistungshalbleiterschalters festgestellt werden. In Reaktion auf die Feststellung eines Kurzschluss- und/oder Überstromzustands kann der jeweilige Leistungshalbleiterschalter 104, 106 abgeschaltet werden.

Fig. 1B zeigt verschiedene beispielhafte Signale in der Vorrichtung aus Fig. 1A zur Bereitstellung von elektrischer Energie an eine Last in einem Normalzustand und in einem Kurzschluss- und/oder Überstromzustand. Die oberste Kurve von Fig. 1B zeigt einen beispielhaften Verlauf eines Steuersignals 130 ($U_{GE}$) des Leistungshalbleiterschalters. Der Spannungspegel des Steuersignals 130 schaltet von einem Pegel im ausgeschalteten Zustand $V_{OFF}$ auf einen Pegel im angeschalteten Zustand $V_{ON}$ um. Grundsätzlich können die Pegel von $V_{ON}$ und $V_{OFF}$ beliebig gewählt werden. In einem Beispiel steuert das Steuersignal 130 das Gate des Leistungshalbleiterschalters, und die Pegel $V_{OFF}$ und $V_{ON}$ entsprechen der Gate-Emitter-Spannung des Leistungshalbleiterschalters im ausgeschalteten beziehungsweise eingeschalteten Zustand. Zum Beispiel kann ein Pegel im ausgeschalteten Zustand $V_{OFF}$ für IGBTs zwischen -20V und 0 V liegen (bevorzugt zwischen -15V und -10V) und ein Pegel im angeschalteten Zustand $V_{ON}$ kann für IGBTs zwischen 10V und 20V liegen (bevorzugt zwischen 14,5 V und 15,5 V). Für Leistungs-MOSFETs können entsprechend die Pegel $V_{OFF}$ und $V_{ON}$ der Spannung der Gate-Source-Spannung des Leistungs-MOSFETs im ausgeschalteten beziehungsweise eingeschalteten Zustand entsprechen. Zum Beispiel kann ein Pegel im ausgeschalteten Zustand $V_{OFF}$ für Leistungs-MOSFETs zwischen -15V und 0V liegen und ein Pegel im angeschalteten Zustand $V_{ON}$ kann für MOSFETs zwischen 10V und 20V liegen.

In Fig. 2 ist eine beispielhafte Steuerschaltung 218 dargestellt (die ein Beispiel für eine der Steuerschaltungen 118, 120 aus Fig. 1A ist). Die Steuerschaltung 218 beinhaltet: Eine Vorrichtung zur Detektion eines Verlaufs einer Spannung über einem Leistungshalbleiterschalter 242, einen Komparator 244, eine Treiberschaltung 236 und eine optionale Treiberschnittstelle 234. Die Vorrichtung zur Detektion eines Verlaufs einer Spannung über einem Leistungshalbleiterschalter 242 und der Komparator 244 können in einer Kurzschluss- oder Überstromschutzschaltung 240 kombiniert werden. Allerdings können in der Steuerschaltung 218 auch beide Komponenten separat beinhaltet sein. In einem Beispiel ist der Komparator 244 in der Treiberschaltung 236 beinhaltet und die Treiberschaltung 236 empfängt ein von der Vorrichtung zur Detektion eines Verlaufs einer Spannung über einem Leistungshalbleiterschalter 242 ausgegebenes Detektionssignal 246 ($U_{DET}$).

Die Vorrichtung zur Detektion eines Verlaufs einer Spannung über einem Leistungshalbleiterschalter 242 empfängt ein Signal 222, das für die Kollektor-Emitter-Spannung eines Leistungshalbleiterschalters repräsentativ ist (zum Beispiel Signale 122 oder 124 aus **Fig. 1A**). In Antwort auf dieses Signal 222, das für die Kollektor-Emitter-Spannung des Leistungshalbleiterschalters repräsentativ ist, erzeugt die Vorrichtung zur Detektion eines Verlaufs einer Spannung über einem Leistungshalbleiterschalter 242 das Detektionssignal 246 ($U_{DET}$), das für einen Verlauf der Kollektor-Emitter-Spannung eines Leistungshalbleiterschalters nach einem Anschalten des Leistungshalbleiterschalters repräsentativ ist.

Weiterhin ist die Kurzschluss- oder Überstromschutzschaltung 240 angeordnet, um ein Referenzsignal 248 ($U_{REF}$) zu empfangen. Der Komparator 244 vergleicht das Referenzsignal 248 ($U_{REF}$) und das Detektionssignal 246 ($U_{DET}$) und ermittelt, ob ein Kurzschluss- und/oder Überstromzustand vorliegt. In einem Beispiel detektiert die Kurzschluss- oder Überstromschutzschaltung 240, dass ein Kurzschluss- und/oder Überstromzustand vorliegt, wenn das Detektionssignal 246 ($U_{DET}$), das für einen Verlauf der Kollektor-Emitter-Spannung eines Leistungshalbleiterschalters nach einem Anschalten des Leistungshalbleiterschalters repräsentativ ist, größer ist als das Referenzsignal 248 ($U_{REF}$). Das Referenzsignal 248 ($U_{REF}$) kann ein externes Referenzsignal sein oder auch von der Treiberschaltung 236 an die Kurzschluss- oder Überstromschutzschaltung 240 geliefert werden.

Wie bereits weiter oben beschrieben, sollte die Kollektor-Emitter-Spannung nach Anschalten des Leistungshalbleiterschalters schnell auf einen relativ geringen Wert absinken. Eine über diesen Wert erhöhte Kollektor-Emitter-Spannung ist ein Indikator für das Vorliegen eines Kurzschluss- und/oder Überstromzustands. Die unteren Kurven in **Fig. 1B** verdeutlichen dieses. Auf der linken Seite von **Fig. 1B** ist ein normaler Einschaltvorgang dargestellt. Die Kollektor-Emitter-Spannung 125 ($U_{CE}$) sinkt nach dem Schaltvorgang schnell ab. Aus einem Signal, das für die Kollektor-Emitter-Spannung 125 ($U_{CE}$) repräsentativ ist, erzeugt die Vorrichtung zur Detektion eines Verlaufs einer Spannung über einem Leistungshalbleiterschalter 242 ein Detektionssignal 246 ($U_{DET}$). Das Detektionssignal 246 ($U_{DET}$) sollte bei einem Verlauf der Kollektor-Emitter-Spannung 125 ($U_{CE}$), wie sie in **Fig. 1B** links gezeigt ist, in der Schaltung von **Fig. 2** unterhalb des Referenzsignals 248 ($U_{REF}$) bleiben. Dann wird korrekterweise kein Kurzschluss- oder Überstromfall detektiert. Wie bereits erwähnt kann die Vorrichtung zur Detektion eines Verlaufs einer Spannung über einem Leistungshalbleiterschalter eine fälschliche Detektion eines Kurzschluss- und/oder Überstromzustand verhindern, die durch parasitäre Kapazitäten auftreten kann, indem Einflüsse parasitärer Kapazitäten vermindert oder unterdrückt werden. Diese Funktion kann von derselben Schaltung auch für unterschiedliche Spannungspegel der Kollektor-Emitter-Spannungen (zum Beispiel 200 V und 4,5 kV) verschiedener Leistungshalbleiterschalter, in verschiedenen Betriebszuständen oder für unterschiedliche Schaltverzögerungen verschiedener Leistungshalbleiterschalter breitgestellt werden.

Die Kurzschluss- oder Überstromschutzschaltung 240 kann, wenn sie einen Kurzschluss- und/oder Überstromzustand detektiert hat, ein Fehlersignal 250 ($U_{FT}$) ausgeben. Im Beispiel von Fig. 2 wird ein Fehlersignal 250 ($U_{FT}$) an die Treiberschaltung 236 abgegeben. Die Treiberschaltung 236 kann in Reaktion auf das Fehlersignal 250 den Leistungshalbleiterschalter abschalten, um Schaden an diesem zu verhindern. Allerdings kann in alternativen Anordnungen das Fehlersignal auch in anderer Weise verarbeitet werden. Zum Beispiel kann lediglich das Fehlersignal 250 ($U_{FT}$) an ein weiteres Steuerelement geliefert werden. Dieses weitere Element kann dann zwei oder mehr Leistungshalbleiterschalter in einer vorbestimmten Sequenz abschalten.

Wie bereits beschrieben, kann die Treiberschaltung 236 ein Fehlersignal 250 ($U_{FT}$), das einen Kurzschluss- und/oder Überstromzustand signalisiert, empfangen und den Leistungshalbleiteschalter in Reaktion auf einen detektierten Kurzschluss- und/oder Überstromzustand abschalten. Eine oder mehrere Komponenten der Kurzschluss- oder Überstromschutzschaltung 240 können optional in der Treiberschaltung 236 beinhaltet sein. Beispielsweise kann der Komparator 244 in der Treiberschaltung 236 beinhaltet sein und die Treiberschaltung 236 kann das Referenzsignal 248 ($U_{REF}$) und das Detektionssignal 246 ($U_{DET}$), das für einen Verlauf der Kollektor-Emitter-Spannung repräsentativ ist, empfangen. In einem anderen Beispiel kann das Referenzsignal 248 ($U_{REF}$) intern in der Treiberschaltung erzeugt werden und die Treiberschaltung kann den Komparator 244 beinhalten. Dann empfängt die Treiberschaltung das Detektionssignal 246 ($U_{DET}$). Außerdem kann die Treiberschaltung 236 auch ein Gate-Emitter-Treibersignal 230 ($U_{GE}$) zum Steuern des Leistungshalbleiterschalters liefern.

Im Beispiel von **Fig. 2** ist die Treiberschaltung 236 über eine galvanische Isolation 238 (z.B. einen Transformator) mit der optionalen Treiberschnittstelle 234 verbunden, um Steuersignale von der Systemsteuerung 214 zu empfangen. Die Treiberschnittstelle 234 kann wiederum mit der Systemsteuerung 214 verbunden sein, die Systemeingaben 216 empfängt. Die Treiberschaltung 236 kann von den empfangenen Systemeingaben 216 gesteuert werden.

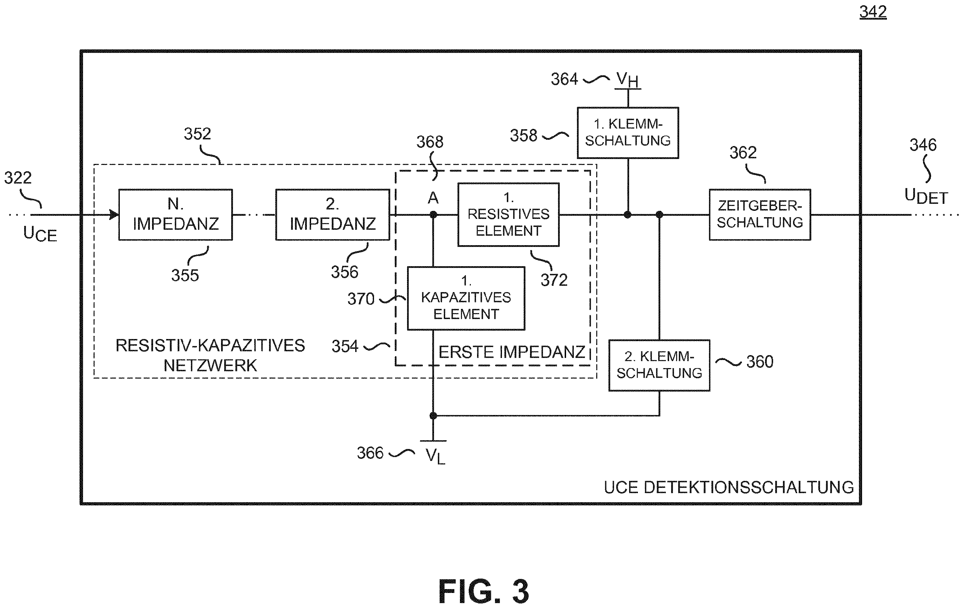

In **Fig. 3** ist eine beispielhafte Vorrichtung zur Detektion eines Verlaufs einer Spannung über einem Leistungshalbleiterschalter 342 (die ein Beispiel für die Detektionsschaltung 242 in **Fig. 2** ist), die in einer Steuerschaltung für einen Leistungshalbleiterschalter eingesetzt werden kann. Die Vorrichtung zur Detektion eines Verlaufs einer Spannung über einem Leistungshalbleiterschalter 342 enthält: Ein resistiv-kapazitives Netzwerk 352, eine Zeitgeber-Schaltung 362, einen erste Klemmschaltung 358 und eine optionale zweite Klemmschaltung 360.

An einem ersten Knoten des resistiv-kapazitiven Netzwerks 352 kann ein Eingangssignal 322 ($U_{CE}$), das für eine Kollektor-Emitter-Spannung eines Leistungshalbleiterschalters repräsentativ ist, gekoppelt werden. Das resistiv-kapazitive Netzwerk 352 stellt zudem an einem zweiten Knoten A ein Signal, das ebenfalls für die Kollektor-Emitter-Spannung eines Leistungshalbleiterschalters repräsentativ ist, bereit (mit einem geringeren Spannungspegel als das Eingangssignal 322 ($U_{CE}$)). Mit diesem zweiten Knoten A ist die Zeitgeber-Schaltung 362 über ein resistives Element 372 verbunden (optional über weitere Elemente). Die Zeitgeber-Schaltung 362 ist also an einen dritten Knoten des resistiv-kapazitiven Netzwerks 352 gekoppelt. In Reaktion auf einen Spannungspegel an dem dritten Knoten erzeugt die Zeitgeber-Schaltung 362 ein Detektionssignal 346 ($U_{DET}$), das für einen Verlauf der Kollektor-Emitter-Spannung eines Leistungshalbleiterschalters nach einem Anschalten des Leistungshalbleiterschalters repräsentativ ist. In manchen Beispielen kann die Zeitgeberschaltung 362 eine Kapazität enthalten, die dazu ausgelegt ist, über eine vorbestimmte Schwellspannung geladen zu werden, falls die Spannung am zweiten Knoten A nach Anschalten des Leistungshalbleiterschalters nicht unter einen vorbestimmten Wert fällt. Die Spannung, die über der Kapazität der Zeitgeberschaltung 362 anliegt kann somit als Detektionssignal 346 ($U_{DET}$) verwendet werden. Allerdings kann die Zeitgeberschaltung auch auf andere Weise implementiert werden. Zum Beispiel kann eine digitale Schaltung als Zeitgeberschaltung eingesetzt werden.

Das resistiv-kapazitive Netzwerk 352 enthält ein erstes kapazitives Element 370, das zwischen dem zweiten Knoten A und einem vierten Knoten des resistiv-kapazitiven Netzwerks 352 gekoppelt ist. Der vierte Knoten des resistiv-kapazitiven Netzwerks 352 liegt auf einem zweiten Referenzpotential 366 ($V_L$). Zudem enthält das resistiv-kapazitive Netzwerk 352, wie oben beschrieben, das erste resistive Element 372, das zwischen den zweiten Knoten A und den dritten Knoten gekoppelt ist. Ein oder mehrere Impedanzen 355, 356 sind zwischen den ersten Knoten, an den das Eingangssignal 322 ($U_{CE}$) gekoppelt ist, und den zweiten Knoten A geschaltet.

Die erste Klemmschaltung 358 ist zwischen den dritten Knoten des resistiv-kapazitiven Netzwerks 352 und ein erstes Referenzpotential 364 ($V_H$) gekoppelt. Die erste Klemmschaltung 358 ist dazu ausgelegt, die Spannung an dem dritten Knoten auf das erste Referenzpotential 364 ($V_H$) zu begrenzen. Der Wert des ersten Referenzpotentials 364 ($V_H$) kann frei gewählt werden unter einem Pegel des Eingangssignals 322 ($U_{CE}$). Das erste Referenzpotential 364 ($V_H$) kann zeitlich variabel sein. Da der Pegel des Eingangssignals 322 ($U_{CE}$) der (unter Umständen hohen) Kollektor-Emitter-Spannung eines Leistungshalbleiterschalters entspricht, kann der Wert des ersten Referenzpotentials 364 ($V_H$) unter einem Zehntel oder sogar unter einem Hundertstel eines Pegels des maximalen Eingangssignals 322 ($U_{CE}$) liegen. Zudem muss der Wert des ersten Referenzpotentials 364 ($V_H$) über dem Pegel des Referenzsignals $U_{REF}$ 248 (siehe **Fig. 2**) liegen, wenn ein Komparator wie in **Fig. 2** eingesetzt wird, um das Detektionssignal 346 zur Detektion eines Kurzschluss- oder Überstromzustands mit einem Referenzsignal zu vergleichen. In einem Beispiel kann ein Pegel des Steuersignals 130 ($U_{GE}$) im angeschalteten Zustand $V_{ON}$ als erstes Referenzpotential 364 ($V_H$) verwendet werden. Das kann vorteilhaft sein, da diese Spannung in der Treiberschaltung 236 (siehe **Fig. 2**) bereits zur Verfügung stehen kann.

Solange das Eingangssignal 322 ($U_{CE}$) einen so hohen Wert hat, dass der Spannungspegel am dritten Knoten des resistiv-kapazitiven Netzwerks oberhalb des ersten Referenzpotentials 364 ($V_H$) liegt (gegebenenfalls zuzüglich eines Spannungsabfalls über Elemente der ersten Klemmschaltung 358 wie beispielsweise einer Diode), wird die Spannung an dem dritten Knoten von der ersten Klemmschaltung 358 auf das erste Referenzpotential 364 ($V_H$) geklemmt (gegebenenfalls zuzüglich Spannungsabfalls über Elemente der ersten Klemmschaltung, zum Beispiel einer Diode). In diesem Zustand bilden die Elemente des resistiv-kapazitiven Netzwerks 352 im dynamischen Ersatzschaltbild einen resistiv-kapazitiven Spannungsteiler. Im dynamischen Ersatzschaltbild liegt das erste resistive Element 372 parallel zu dem ersten kapazitiven Element 370 (da es nur eine statische Spannungsdifferenz zwischen dem zweiten Referenzpotential 366 ($V_L$) und dem ersten Referenzpotential 364 ($V_H$) gibt, sind der dritte Knoten und der vierte Knoten im dynamischen Ersatzschaltbild kurzgeschlossen). Das erste resistive Element 372 und das erste kapazitive Element 370 können also zu einer (virtuellen) ersten Impedanz 354 zusammengefasst werden. Der dynamische Anteil des Eingangssignals 322 ($U_{CE}$) fällt also über einer Serienschaltung der ein oder mehreren Impedanzen 355, 356 und den ersten Impedanz (354) ab. Das hat zur Folge, dass am zweiten Knoten A 368 der dynamische Anteil des Eingangssignals 322 ($U_{CE}$) gemäß dem Verhältnis der ein oder mehreren Impedanzen 355, 356 und der ersten Impedanz 354 heruntergeteilt wird.

Wenn das Eingangssignals 322 ($U_{CE}$) auf einen so niedrigen Wert gesunken ist, dass der Spannungspegel am dritten Knoten des resistiv-kapazitiven Netzwerks unterhalb des ersten Referenzpotentials 364 ($V_H$) liegt (erneut gegebenenfalls zuzüglich eines Spannungsabfalls über Elementen der ersten Klemmschaltung 358 wie beispielsweise einer Diode), gibt die erste Klemmschaltung 358 die Spannung am dritten Knoten des resistiv-kapazitiven Netzwerks frei. In diesem Fall bilden die Elemente des resistiv-kapazitiven Netzwerks 352 im dynamischen Ersatzschaltbild wieder einen resistiv-kapazitiven Spannungsteiler, wobei gegebenenfalls resistive Elemente der Zeitgeberschaltung 362 dynamisch in Serie mit dem ersten resistiven Element 372 liegen. Das kann dazu führen, dass sich die dynamischen Eigenschaften des resistiv-kapazitiven Spannungsteilers durch Zuschalten der resistiven Elemente der Zeitgeberschaltung 352 verändern. Trotzdem wird erneut am zweiten Knoten A 368 der dynamische Anteil des Eingangssignals 322 ($U_{CE}$) heruntergeteilt.

In beiden vorstehend beschriebenen Betriebszuständen teilt der durch das resistiv-kapazitive Netzwerk 352 (und gegebenenfalls Elemente der Zeitgeberschaltung 362) gebildete resistiv-kapazitive Spannungsteiler den dynamischen Anteil des Eingangssignals 322 ($U_{CE}$) auf einen vorbestimmten, niedrigeren Spannungspegel am zweiten Knoten A.

Die Anzahl der Impedanzen des resistiv-kapazitiven Netzwerks 352 ist frei wählbar. So kann ein gewünschter Wert des Spannungspegels am Knoten A für eine bestimmten Spannungspegel des Eingangssignal 322 ($U_{CE}$) durch verschiedene Kombinationen von Impedanzen eingestellt werden. Es ist auf der einen Seite möglich, eine größere Anzahl von Impedanzen mit niedrigerem Wert in Reihe zu schalten. Auf der anderen Seite kann auch eine kleine Anzahl oder sogar nur zwei Impedanzen verwendet werden, die entsprechend höhere Werte haben müssen. In einem Beispiel können die Impedanzen so ausgewählt werden, dass ein Strom, der in dem resistiv-kapazitiven Netzwerk 352 bei Anschluss einer Kollektor-Emitter-Spannung ($U_{CE}$) eines Leistungshalbleiterschalters fließt, eine vorbestimmte Stromstärke nicht überschreitet (zum Beispiel 1,5 mA statisch bzw. als Mittelwert).

Wie bereits weiter oben beschrieben, kompensiert das resistiv-kapazitive Netzwerk 352 die parasitären Kapazitäten der Vorrichtung zur Detektion eines Verlaufs einer Spannung über einem Leistungshalbleiterschalter 342 oder kompensiert die parasitären Kapazitäten über. Die Spannung am zweiten Knoten A fällt somit bei fallendem Eingangssignal 322 ($U_{CE}$) stärker ab, als dies der Fall wäre, wenn die parasitären Kapazitäten der Vorrichtung zur Detektion eines Verlaufs einer Kollektor-Emitter-Spannung 342 nicht kompensiert würden. Damit ist die Spannung am zweiten Knoten A eine vorbestimmte Zeit nach dem Beginn des Anschaltvorgangs niedriger als bei einer fehlenden Kompensierung der parasitären Kapazitäten. In Folge dessen wird verhindert, dass eine Kapazität der Zeitgeberschaltung 362 über die vorbestimmte Schwellspannung (die auch als Referenzsignal bezeichnet wird, das benutzt wird, um zu detektieren, ob ein Kurzschluss- oder Überstromfall vorliegt) geladen wird, wenn kein Kurzschluss- oder Überstromzustand vorliegt (das Eingangssignal 322 ($U_{CE}$) folglich einen wie in **Fig. 1B** links gezeigten Verlauf hat). Wenn alternative Zeitgeberschaltungen eingesetzt werden, kann der niedrigere Pegel der Spannung am zweiten Knoten A ebenfalls eine Ausgabe eines Detektionssignals mit einem zu hohen Pegel verhindern und eine fälschliche Detektion eines Kurzschluss- oder Überstromzustands vermeiden. Zudem sorgt der Einsatz des resistiv-kapazitiven Netzwerks 352 (das im dynamischen Ersatzschaltbild einen resistiv-kapazitiven Spannungsteiler bildet) dafür, dass Änderungen in dem Eingangssignal 322 ($U_{CE}$) sich ohne substantielle Verzögerung in einer Änderung des Spannungspegels am zweiten Knoten A niederschlagen.

Die zweite optionale Klemmschaltung 360 ist dazu ausgelegt, eine Spannung an dem dritten Knoten auf eine vorbestimmte Minimalspannung zu begrenzen. Der Wert der vorbestimmten Minimalspannung kann frei gewählt werden (und kann auch zeitlich variieren) und muss unter dem Pegel des Referenzsignals $U_{REF}$ 248 (siehe **Fig. 2**) liegen, wenn ein Komparator wie in **Fig. 2** eingesetzt wird, um das Detektionssignal 346 mit einem Referenzsignal zu vergleichen (um einen Kurzschluss- oder Überstromzustand zu detektieren). In einem Beispiel kann ein Pegel des Steuersignals 130 im ausgeschalteten Zustand $V_{OFF}$ als vorbestimmte Minimalspannung verwendet werden. Das kann vorteilhaft sein, da diese Spannung in der Treiberschaltung 236 (siehe **Fig. 2**) bereits zur Verfügung stehen kann. Zudem kann optional die zweite Klemmschaltung 360 den Pegel des dritten Knotens auf das zweite Referenzpotential 366 ($V_L$) klemmen, auf dem auch der vierte Knoten des resistiv-kapazitiven Netzwerks 352 liegt. Die zweite optionale Klemmschaltung 360 kann zum Schutz der Komponenten der Vorrichtung zur Detektion eines Verlaufs einer Spannung über einem Leistungshalbleiterschalter 342 und auch der mit ihr verbundenen Komponenten dienen (zum Beispiel einer Treiberschaltung 236 aus **Fig. 2**).

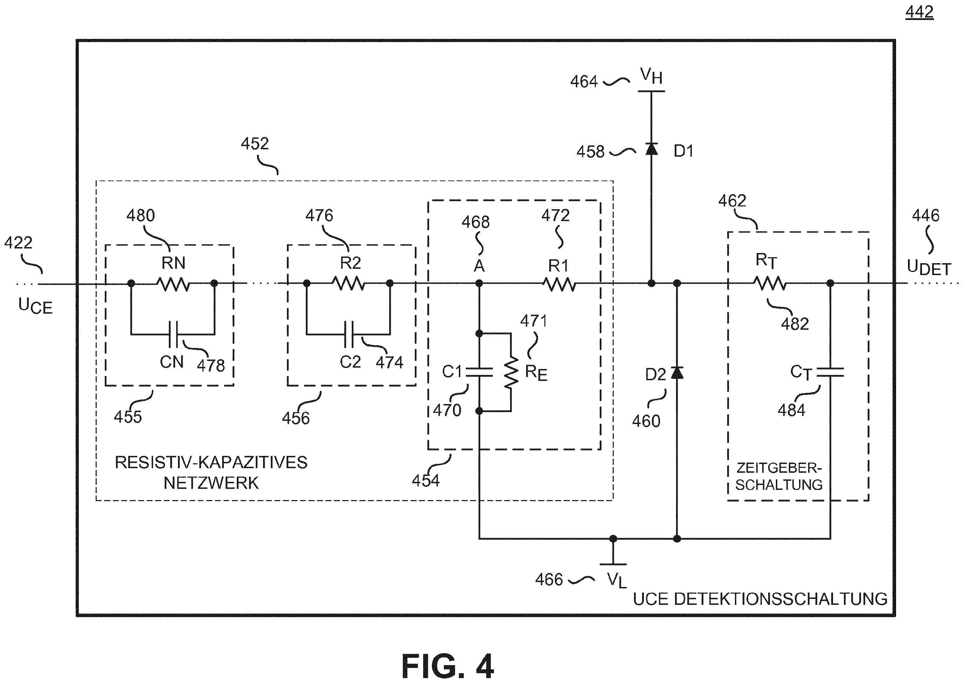

**Fig. 4** zeigt eine weitere beispielhafte Vorrichtung zur Detektion eines Verlaufs einer Spannung über einem Leistungshalbleiterschalter 442. Wie auch die Vorrichtung in **Fig. 3,** weist die Vorrichtung in **Fig. 4** auf: Ein resistiv-kapazitives Netzwerk 452, eine Zeitgeber-Schaltung 462, eine erste Klemmschaltung 458 und eine optionale zweite Klemmschaltung 460. Diese sind genauso angeordnet und funktionieren wie in Bezug auf **Fig. 3** beschrieben.

Ein erstes kapazitives Element 470 des resistiv-kapazitiven Netzwerks 452 ist zwischen einen zweiten Knoten A 468 und einen vierten Knoten gekoppelt. Beispielsweise kann der vierte Knoten sich auf einem Spannungspegel einer vorbestimmten Minimalspannung einer zweiten Klemmschaltung 460 befinden. Zudem ist ein erstes resistives Element 472 ($R_1$) zwischen einen zweiten Knoten A 468 und einen dritten Knoten des resistiv-kapazitiven Netzwerks 452 gekoppelt. Das erste resistive Element 472 ($R_1$) kann einen Wert zwischen 10 kΩ und 1 MΩ haben. Wie in Zusammenhang mit **Fig. 3** ausgeführt, bilden das erste resistive Element 472 ($R_1$) und das erste kapazitive Element 470 dynamisch gesehen eine erste Impedanz 454 eines resistiv-kapazitiven Spannungsteilers.

Des Weiteren weist das resistiv-kapazitive Netzwerk 452 ein oder mehr weitere Impedanzen 455, 456 auf, die zwischen den zweiten Knoten A 468 und den ersten Knoten des resistiv-kapazitiven Netzwerks 452, an das die Kollektor-Emitter-Spannung 422 ($U_{CE}$) gekoppelt ist, geschaltet sind. Im Beispiel von **Fig. 4** enthält das resistiv-kapazitive Netzwerk 452 N-1 weitere Impedanzen 455, 456 (wobei N eine natürliche Zahl größer eins ist). Zudem weist jede der N-1 Impedanzen 455, 456 ein weiteres kapazitives Element 474, 478 ($C_2$, $C_N$) und ein jeweils mit einem kapazitiven Element 474, 478 ($C_2$, $C_N$) parallel gekoppeltes weiteres resistives Element 476, 480 ($R_2$, $R_N$) auf. Diese Anordnung ist allerdings nicht zwingend. So können mehrere Impedanzen 455, 456 ein gemeinsames kapazitives Element haben, das parallel zu den jeweiligen resistiven Elementen geschaltet ist. Umgekehrt können mehrere Impedanzen 455, 456 ein gemeinsames resistives Element haben, das parallel zu den jeweiligen kapazitiven Elementen geschaltet ist. In einem Beispiel sind die Werte der kapazitiven Elemente 474, 478 ($C_2$, $C_N$) der Impedanzen 455, 456, die zwischen den zweiten Knoten A 468 und den ersten Knoten des resistiv-kapazitiven Netzwerks 452 geschaltet sind, gleich (beispielsweise zwischen 0,5 pF und 200 pF). Zudem können auch die Werte der resistiven Elemente 476, 480 ($R_2$, $R_N$) der Impedanzen 455, 456, die zwischen den zweiten Knoten A 468 und den ersten Knoten des resistiv-kapazitiven Netzwerks 452 geschaltet sind, einen gleichen Wert haben (zum Beispiel zwischen 10 kΩ und 1 MΩ). Wie ebenfalls im Zusammenhang mit **Fig. 3** beschrieben, bilden die weiteren Impedanzen 455, 456 und die erste Impedanz 454 im dynamischen Ersatzschaltbild einen resistiv-kapazitiven Spannungsteiler, der einen dynamischen Anteil des Eingangssignals 422 ($U_{CE}$) herunterteilt.

Die Werte des ersten kapazitiven Elements 470 ($C_1$) und der weiteren kapazitiven Elemente 474, 478 ($C_2$, $C_N$) können ausgewählt sein, um die parasitären Kapazitäten der Vorrichtung zur Detektion eines Verlaufs einer Spannung über einem Leistungshalbleiterschalter 442 zu kompensieren oder überzukompensieren (oder leicht unterzukompensieren). Im Allgemeinen führt eine Erhöhung des Wertes einer der weiteren kapazitiven Elemente 474, 478 ($C_2$, $C_N$) in Richtung Überkompensation. Gleichsam führt eine Verringerung eines Wertes des ersten kapazitiven Elements 470 ($C_1$) in Richtung Überkompensation. Umgekehrt führt eine Verringerung des Wertes einer der weiteren kapazitiven Elemente 474, 478 ($C_2$, $C_N$) in Richtung Unterkompensation. Gleichsam führt eine Erhöhung eines Wertes des ersten kapazitiven Elements 470 ($C_1$) in Richtung Unterkompensation. Also kann der Wert einer eines oder mehrerer der weiteren kapazitiven Elemente 474, 478 ($C_2$, $C_N$) zum Erzielen einer Überkompensation höher sein als im exakt kompensierten Fall sein. Alternativ kann der der Wert einer der weiteren kapazitiven Elemente 474, 478 ($C_2$, $C_N$) zum Erzielen einer Unterkompensation kleiner sein als im exakt kompensierten Fall sein.

Zum Beispiel könnte der Wert des ersten kapazitiven Elements 470 ($C_1$) um einige zehn Picofarad (zum Beispiel 3 pF bis 20 pF) unter dem Wert der weiteren kapazitiven Elemente 474, 478 ($C_2$, $C_N$) der weiteren Impedanzen 455, 456 liegen, um die parasitären Kapazitäten zu kompensieren. Alternativ kann der Wert des ersten kapazitiven Elements 470 ($C_1$) geringer sein als im kompensierten Fall, um die parasitären Kapazitäten überzukompensieren (oder auch höher, um die parasitären Kapazitäten bis zu einem gewissen Grad unterzukompensieren). Auch kann in einem Beispiel der Wert der weiteren kapazitiven Elemente 474, 478 ($C_2$, $C_N$) bis zu 20 pF über dem Wert für den kompensierten Fall liegen, um die parasitären Kapazitäten überzukompensieren.

Zudem kann jedes kapazitive Element des resistiv-kapazitiven Netzwerks 452 einen Wert haben, der mindestens dem achtfachen Wert der parasitären Kapazitäten der Vorrichtung zur Detektion eines Verlaufs einer Spannung über einem Leistungshalbleiterschalter 442 entspricht.

In der Vorrichtung zur Detektion eines Verlaufs einer Spannung über einem Leistungshalbleiterschalter 442 gemäß **Fig. 4** können erste und zweite Klemmschaltungen 458, 460 vorgesehen sein, die wie die entsprechenden ersten und zweiten Klemmschaltungen 360, 358 in **Fig. 3** ausgestaltet sind. In einem Bespiel können die ersten und zweiten Klemmschaltungen 458, 460 jeweils eine Diode enthalten.

Das optionale resistive Element 471 ($R_E$) ist parallel zu dem ersten kapazitiven Element 470 geschaltet. Das optionale resistive Element 471 ($R_E$) kann ausgelegt sein, um einen stationären Pegel des Detektionssignals 446 (mindestens teilweise) zu bestimmen. Es kann einen Wert zwischen 1 MΩ und 20 MΩ haben. Wenn der Spannungspegel der Kollektor-Emitter-Spannung 422 ($U_{CE}$) einige Zeit nach einem Umschaltvorgang ungefähr stationär ist, wird die Spannung am Knoten A 468 durch die resistiven Elemente des resistiv-kapazitiven Netzwerks 452 (zumindest teilweise) bestimmt. Dann kann das optionale resistive Element 471 ($R_E$) dazu beitragen, den Spannungspegel am zweiten Knoten A zu bestimmen. Der Spannungspegel am zweiten Knoten A beeinflusst, bis auf welchen Wert eine Kapazität der Zeitgeberschaltung 462 (die weiter unten erläutert wird) in einem Normalfall und einem Kurzschluss- oder Überstromfall geladen oder entladen wird, und so den stationären Pegel des Detektionssignals 446. Das optionale resistive Element 471 ($R_E$) kann also dafür ausgewählt werden, um den stationären Pegel des Detektionssignals 446 festzulegen. Ohne das optionale resistive Element 471 ($R_E$) entspricht der Spannungspegel am zweiten Knoten A im stationären Zustand dem Pegel des Eingangssignals 422 ($U_{CE}$), wenn keine der ersten oder zweiten Klemmschaltungen 458, 460 leiten.

Wie bereits beschrieben, kompensiert das resistiv-kapazitive Netzwerk 452 die parasitären Kapazitäten der Vorrichtung zur Detektion eines Verlaufs einer Spannung über einem Leistungshalbleiterschalter 442 (oder kompensiert die parasitären Kapazitäten über). Zu den parasitären Kapazitäten können, je nach konkreter Ausgestaltung der Vorrichtung 442, verschiedene Komponenten beitragen. Zum Beispiel können PCB-Layout-Kapazitäten zu den parasitären Kapazitäten der Vorrichtung zur Detektion eines Verlaufs einer Spannung über einem Leistungshalbleiterschalter 442 beitragen. Zusätzlich können auch Kapazitäten der Dioden der ersten und zweiten Klemmschaltungen 458, 460 zu den parasitären Kapazitäten der Vorrichtung zur Detektion eines Verlaufs einer Spannung über einem Leistungshalbleiterschalter 442 beitragen. In einem Beispiel liegen PCB-Layout-Kapazitäten als parasitären Kapazitäten parallel zu dem ersten kapazitiven Element 470 ($C_1$).

Die Zeitgeberschaltung 462 enthält ein RC-Glied, das die Kapazität 484 ($C_T$) der Zeitgeberschaltung 462 und ein resistives Element 482 ($R_T$) beinhaltet. Der Spannungspegel an einem ersten Ende der Kapazität 484 ($C_T$) der Zeitgeberschaltung 462 kann das Detektionssignal 446 sein, das für einen Verlauf der Kollektor-Emitter-Spannung eines Leistungshalbleiterschalters nach einem Anschalten des Leistungshalbleiterschalters repräsentativ ist. Allerdings sind auch andere Ausgestaltungen der Zeitgeberschaltung möglich. Zum Beispiel kann eine digitale Schaltung den Spannungspegel am dritten Knoten des resistiv-kapazitiven Netzwerks 452 abtasten und das Detektionssignal 446 in Abhängigkeit von dem Spannungspegel am dritten Knoten erzeugen.

Wenn ein Komparator wie in **Fig. 2** eingesetzt wird, um das Detektionssignal 446 mit einem Referenzspannung zu vergleichen zur Detektion eines Kurzschluss- oder Überstromzustands, wird die Kapazität 484 ($C_T$) auf einen Pegel unterhalb der Referenzspannung gehalten solange der Leistungshalbleiterschalter in einem ausgeschalteten Zustand ist. Beispielsweise kann die Kapazität 484 ($C_T$) auf einen Spannungspegel des Steuersignals 130 im ausgeschalteten Zustand $V_{OFF}$ gehalten werden.

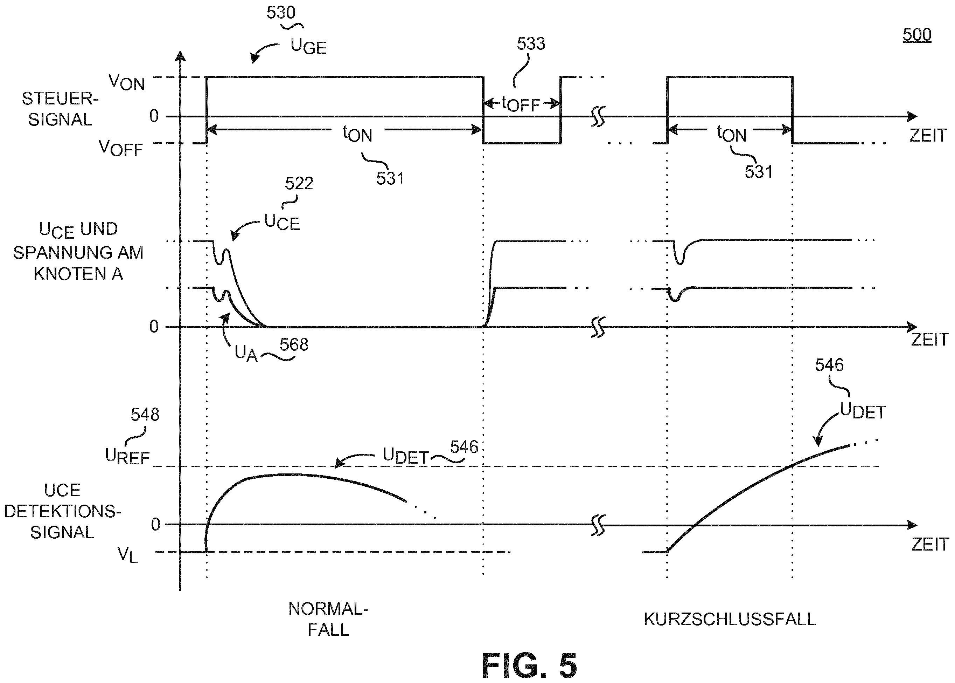

In einem Beispiel ist das erste Ende der Kapazität 484 ($C_T$) mit einem Schalter (nicht in **Fig. 4** gezeigt) verbunden. Der Schalter kann in Antwort auf ein Ausschalten des Leistungshalbleiterschalters das erste Ende der Kapazität 484 ($C_T$) auf den Pegel unterhalb der Referenzspannung klemmen. Die Kapazität 484 ($C_T$) wird dann soweit entladen, bis der Pegel unterhalb der Referenzspannung erreicht ist (nicht in **Fig. 5** gezeigt).

Nach dem Anschalten des Leistungshalbleiterschalters wird die Kapazität 484 ($C_T$) der Zeitgeberschaltung 462 geladen, so dass der Spannungspegel des Detektionssignals 446, das für einen Verlauf der Kollektor-Emitter-Spannung eines Leistungshalbleiterschalters nach einem Anschalten des Leistungshalbleiterschalters repräsentativ ist, steigt. Wenn, wie im letzten Absatz aufgeführt, ein Schalter dazu eingesetzt wird, um das erste Ende der Kapazität 484 ($C_T$) auf den Pegel unterhalb der Referenzspannung zu klemmen, wird dieser in Reaktion auf das Anschalten des Leistungshalbleiterschalters geöffnet. Das erste Ende der Kapazität 484 ($C_T$) wird damit freigegeben und der Spannungspegel des Detektionssignals 446 kann abhängig von dem Verlauf der Kollektor-Emitter-Spannung eines Leistungshalbleiterschalters steigen.

Wenn nun die Kollektor-Emitter-Spannung 422 ($U_{CE}$) nicht nach Anschalten des Leistungshalbleiterschalters unter einen vorbestimmten Wert fällt, so wird die Kapazität 484 ($C_T$) der Zeitgeberschaltung 462 über eine vorbestimmte Schwellspannung geladen (zum Beispiel den Spannungspegel des Referenzsignals 248 in **Fig. 2**). Dieses Verhalten ist auf der rechten Seite in **Fig. 5** dargestellt. Beispielhafte Verläufe des Steuersignals 530, der Kollektor-Emitter-Spannung 522, der Spannung am Knoten A 568 und des Detektionssignals 546 im Kurzschluss- oder Überstromfall sind auf der rechten Seite der **Fig. 5** gezeigt. Die oberste Kurve zeigt einen idealisierten Verlauf eines beispielhaften Steuersignals 530 ($U_{GE}$). Wie in der mittleren Kurve rechts zu sehen, fällt die Kollektor-Emitter-Spannung 522 ($U_{CE}$) des Leistungshalbleiterschalters in bestimmten Kurzschlussfällen nur leicht ab und kehrt dann auf einen relativ hohen Pegel zurück. In anderen Kurzschlussfällen kann die Kollektor-Emitter-Spannung zunächst auf einen Pegel im Normalfall absinken und nach einiger Zeit wieder ansteigen. In der Folge ist auch ein Spannungspegel am Knoten A 568 ($V_A$) höher als im Normalfall. In der Folge wird die Spannung an einem Ende der Kapazität der Zeitgeberschaltung (das Detektionssignal 546) über den Spannungspegel des Referenzsignals 548 ($U_{REF}$) gehoben. In anderen Worten, die Kapazität 484 ($C_T$) wird geladen, so dass das Detektionssignal 546 ($U_{DET}$) sich über die vorbestimmte Schwellspannung erhöht. Das kann eine Kurzschluss- oder Überstromschutzschaltung (zum Beispiel Schaltung 240 in **Fig. 2**) detektieren, und ein entsprechendes Fehlersignal ausgeben. In der Folge kann eine Steuerschaltung den Leistungshalbleiterschalter abschalten, und eine AN-Zeit 531 ($t_{ON}$) kurz genug halten, so dass der Leistungshalbleiterschalter keinen Schaden nimmt. Die Zeitkonstante des Anstiegs des Detektionssignals 546 kann durch die Werte der Kapazität 484 ($C_T$) und des resistiven Elements 482 ($R_T$) der Zeitgeberschaltung 462 zumindest teilweise bestimmt werden. Die Kapazität 484 ($C_T$) kann auch über den Spannungspegel des Referenzsignals 548 ($U_{REF}$) geladen werden, wenn ein Kurzschluss- oder Überstromfall auftritt, nachdem die Kollektor-Emitter-Schaltung des Leistungshalbleiterschalters bereits auf ihren stationären Wert im AN-Zustand abgefallen war.

Wenn nun die Kollektor-Emitter-Spannung 422 ($U_{CE}$) nach Anschalten des Leistungshalbleiterschalters unter den vorbestimmten Wert fällt, so verhindert die Vorrichtung 442, dass die Spannung über der Kapazität 484 ($C_T$) der Zeitgeberschaltung 462 über die vorbestimmte Schwellspannung geladen wird (zum Beispiel den Spannungspegel des Referenzsignals 248 in **Fig. 2**). In anderen Worten, die Vorrichtung 442 verhindert, dass die Kapazität 484 geladen wird, so dass das Detektionssignal 546 nicht über die vorbestimmte Schwellspannung steigt. Beispielhafte Verläufe des Steuersignals 530, der Kollektor-Emitter-Spannung 522, der Spannung am Knoten A 568 und des Detektionssignals 546 im Normalfall sind auf der linken Seite der **Fig. 5** gezeigt. Auf der linken Seite von **Fig. 5** sind einige Signale im Normalfall gezeigt. Ganz oben ist wiederum ein beispielhaftes Steuersignal 530 ($U_{GE}$) eines Leistungshalbleiterschalters skizziert.

Die Länge AN-Zeit 531 ($t_{ON}$) und die Länge der AUS-Zeit 533 ($t_{OFF}$) können von einer Systemsteuerung (zum Beispiel Systemsteuerung 214 in **Fig. 2**) gemäß den Ansprüchen eines Leistungswandlers gesteuert werden. Die Steuerschaltung 218 kann den Leistungshalbleiterschalter zudem in Reaktion auf verschiedene Fehlerfälle abschalten (beispielsweise in Reaktion auf das Fehlersignal 250 ($U_{FT}$) in **Fig. 2**). Wie in der mittleren Kurve links gezeigt, fällt die Kollektor-Emitter-Spannung 522 ($U_{CE}$) des Leistungshalbleiterschalters im Normalfall stark ab (bis auf einen Pegel nahe 0 V). Gleichzeitig fällt auch der Spannungspegel am zweiten Knoten A 568 ($U_A$) ab. In der Folge wird die Kapazität der Zeitgeberschaltung zunächst geladen, so dass der Spannungspegel des Detektionssignals 546 ansteigt. Wenn aber die Kollektor-Emitter-Spannung 522 ($U_{CE}$) des Leistungshalbleiterschalters (und somit auch die Spannung am Knoten A 568) unter einen vorbestimmten Wert gefallen ist, wird die Kapazität 484 der Zeitgeberschaltung 462 nicht weiter geladen. Im Gegenteil, die Vorrichtung zur Detektion eines Verlaufs einer Spannung über einem Leistungshalbleiterschalter 442 kann die Kapazität 484 der Zeitgeberschaltung 462 entladen. So bleibt der Spannungspegel des Detektionssignals 546 unterhalb einer Referenzspannung 548 und die Kurzschluss- oder Überstrom-Detektionsschaltung löst nicht aus.

Durch die erste Klemmschaltung 458 kann der Detektionszeitpunkt eines Kurzschluss- oder Überstromzustands im Wesentlichen von der Amplitude der Kollektor-Emitter-Spannung ($U_{CE}$) des Leistungshalbleiterschalters im ausgeschalteten Zustand unabhängig gemacht werden. Zum Beispiel kann der Detektionszeitpunkt für Leistungshalbleiterschalter etwa 4 μs bis 20 μs nach einem Start eines Anschaltvorgangs liegen, unabhängig von der Kollektor-Emitter-Spannung ($U_{CE}$) des Leistungshalbleiterschalters im ausgeschalteten Zustand (die beispielsweise in einem ersten Betriebsmodus 1,2 kV betragen kann und in einem zweiten Betriebsmodus 4,5 kV). Wie oben beschrieben, kann die erste Klemmschaltung 458 den Spannungspegel am dritten Knoten des resistiv-kapazitiven Netzwerks 452 auf ein erstes Referenzpotential 464 ($V_H$) klemmen, solange ein Spannungspegel am zweiten Knoten A oberhalb des ersten Referenzpotentials ($V_H$) liegt (gegebenenfalls zuzüglich eines Spannungsabfalls über Elementen der ersten Klemmschaltung 458). Wenn ein resistives Element 471 ($R_E$) parallel zu dem ersten kapazitiven Element 470 geschaltet ist, klemmt die erste Klemmschaltung 458, solange das heruntergeteilte Eingangssignal 422 ($U_{CE}$) einen höheren Spannungspegel als das erste Referenzpotential 464 ($V_H$) hat (wieder gegebenenfalls zuzüglich eines Spannungsabfalls über Elementen der ersten Klemmschaltung 458). Dieses Verhalten ist unabhängig von der jeweiligen Kollektor-Emitter-Spannung ($U_{CE}$) des Leistungshalbleiterschalters im ausgeschalteten Zustand. Folglich wird die Kapazität 484 ($C_T$) der Zeitgeberschaltung 462 auch unabhängig von der jeweiligen Kollektor-Emitter-Spannung ($U_{CE}$) des Leistungshalbleiterschalters gleich schnell geladen.

In den bisherigen Beispielen wurde ausgeführt, wie ein resistiv-kapazitives Netzwerk die parasitären Kapazitäten der Vorrichtung zur Detektion eines Verlaufs einer Kollektor-Emitter oder Drain-Source-Spannung eines Leistungshalbleiterschalters kompensieren oder überkompensieren kann, um fälschliche Detektionen eines Kurzschluss- oder Überstromzustands zu vermeiden. Allerdings müssen die kapazitiven Elemente des resistiv-kapazitiven Netzwerks nicht unbedingt zusätzliche Bauelemente sein. In einem Beispiel sind ein oder mehrere der kapazitiven Elemente des resistiv-kapazitiven Netzwerk selbst parasitäre Kapazitäten der Vorrichtung zur Detektion eines Verlaufs einer Kollektor-Emitter oder Drain-Source-Spannung eines Leistungshalbleiterschalters. Zum Beispiel können PCB-Layout-Kapazitäten der Vorrichtung zur Detektion eines Verlaufs einer Kollektor-Emitter-Spannung eines Leistungshalbleiterschalters als kapazitive Elemente eines resistiv-kapazitiven Netzwerks verwendet werden. Die Anordnung der Komponenten der Vorrichtung zur Detektion eines Verlaufs einer Kollektor-Emitter oder Drain-Source-Spannung eines Leistungshalbleiterschalters kann so gewählt werden, dass PCB-Layout-Kapazitäten geeignete Werte haben, um als ein oder mehrere der kapazitiven Elemente des resistiv-kapazitiven Netzwerk zu fungieren.

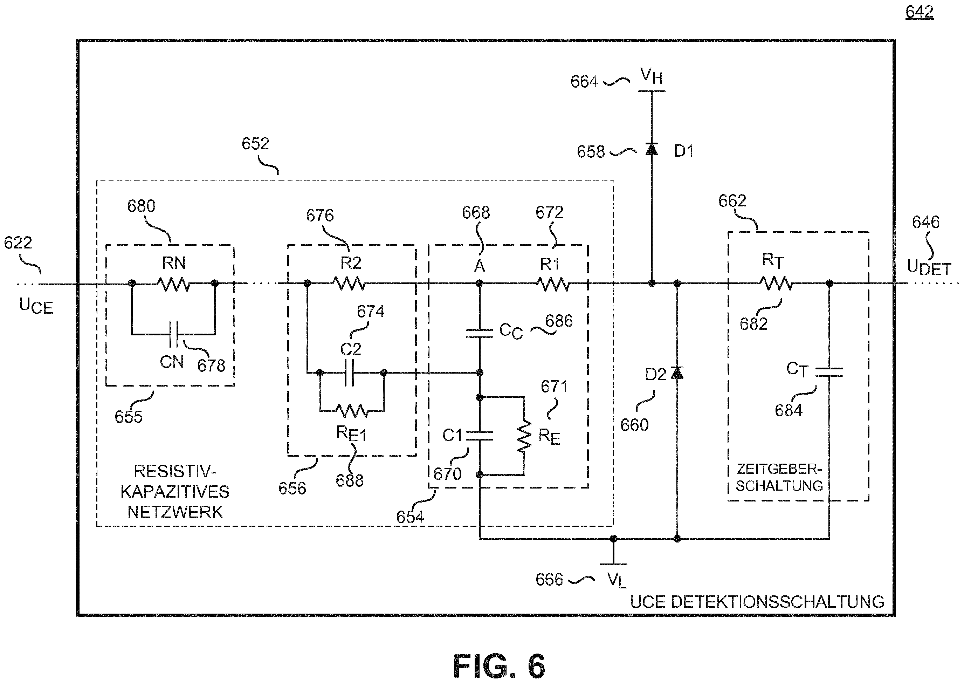

Die Vorrichtung zur Detektion eines Verlaufs einer Spannung über einem Leistungshalbleiterschalter 642 gemäß **Fig. 6** weist alle Komponenten der Vorrichtung zur Detektion eines Verlaufs einer Spannung über einem Leistungshalbleiterschalter 442 gemäß **Fig. 4** auf. Zusätzlich weist die Vorrichtung 642 gemäß **Fig. 6** ein weiteres kapazitives Element 686 (Cc) auf, das zwischen den Knoten A 668 und ein erstes Ende des ersten kapazitiven Elements 670 ($C_1$) gekoppelt ist. Der Wert dieses weiteren kapazitiven Elements 686 (Cc) kann erheblich kleiner (ein Fünftel oder kleiner, oder ein Zehntel oder kleiner) sein als der Wert des kapazitiven Elements 670 ($C_1$). In diesem Fall ist die Kapazität zwischen dem zweiten Knoten A 668 und dem vierten Knoten (der auf dem zweiten Referenzpotential 666 ($V_L$) liegt) fast gleich dem Wert des weiteren kapazitiven Elements 686 (Cc) (ungefähr gleich $\frac{1}{1/C_c + 1/C_1}$). Auch kann das weitere kapazitive Element 686 (Cc) erheblich kleiner (ein Fünftel oder kleiner, oder ein Zehntel oder kleiner) sein als die Kapazität 684 ($C_T$) der Zeitgeberschaltung 662. Auf diese Weise kann das weitere kapazitive Element 686 (Cc) einen Einfluss des ersten kapazitiven Elements 670 ($C_1$) auf einen Spannungspegel am zweiten Knoten A reduzieren, wenn das Signal, das für die Spannung über dem Leistungshalbleiterschalter repräsentativ ist unterhalb der ersten Maximalspannung 664 und oberhalb der Referenzspannung 248 liegt. Das kann zu Folge haben, dass die Ladezeit der Kapazität 684 ($C_T$) der Zeitgeberschaltung 662 und somit auf die Zeitspanne, bis ein Kurzschluss- oder Überstromzustand detektiert wird in diesem Betriebsbereich weniger stark von der Kollektor-Emitter-Spannungen ($U_{CE}$) eines Leistungshalbleiterschalters im ausgeschalteten Zustand abhängt. Das weitere kapazitive Element 686 (Cc) kann somit Unterschiede in der Zeitspanne verringern, innerhalb derer ein Kurzschluss- oder Überstromzustand detektiert wird, besonders im Bereich relativ niedriger Kollektor-Emitter-Spannungen ($U_{CE}$) eines Leistungshalbleiterschalters im ausgeschalteten Zustand (beispielsweise 200 bis 400 V).

Zusätzlich oder alternativ können auch in die weiteren Impedanzen 656, 655 des resistiv-kapazitiven Netzwerks 652 weitere kapazitive Elemente eingefügt werden. So kann in der zweiten Impedanz 656 parallel zu einem zweiten resistiven Element 676 ($R_2$) und in Serie mit einem zweiten kapazitiven Element 674 ($C_2$) eine zweite weiteres kapazitives Element (nicht in **Fig. 6** gezeigt) eingefügt werden. Zudem ist ein Ende des zweiten weiteren kapazitiven Elements, das mit dem zweiten kapazitiven Element 674 ($C_2$) verbunden ist, ebenfalls mit einem kapazitiven Element einer benachbarten Impedanz verbunden. Im Beispiel der **Fig. 6,** wo sich zwischen den Impedanzen 655 und 656 keine weiteren Impedanzen befinden, ist das zweite zusätzliche kapazitive Element an einem Ende mit den resistiven Elementen 676 und 680 ($R_2$ und $R_N$) und an einem anderen Ende mit den kapazitiven Elementen 674 und 678 ($C_2$ und $C_N$) verbunden. Dieses zweite weitere kapazitive Element kann so bemessen sein, dass sie erheblich kleiner (ein Fünftel oder kleiner, oder ein Zehntel oder kleiner) ist als das kapazitive Element 674 ($C_2$) der zweiten Impedanz (656). Somit funktioniert es in Bezug auf das zweite kapazitive Element 674 ($C_2$) der zweiten Impedanz 656 ähnlich, wie das erste weitere kapazitive Element 686 (Cc) in Bezug auf das kapazitive Element 670 ($C_1$). Das zweite weitere kapazitive Element bestimmt im Wesentlichen die Kapazität der Anordnung und vermindert den Einfluss des zweiten kapazitiven Elements 674 ($C_2$) auf die Ladezeit der Kapazität 684 ($C_T$) der Zeitgeberschaltung 662.

Zusätzlich und unabhängig von den weiteren Kapazitäten weist die Vorrichtung zur Detektion eines Verlaufs einer Kollektor-Emitter-Spannung eines Leistungshalbleiterschalters 642 gemäß **Fig. 6** ein weiteres resistives Element 688 ($R_{E1}$) auf, das parallel zu dem zweiten kapazitiven Element 674 ($C_2$) der zweiten Impedanz 656 geschaltet ist. Dieses kann dazu beitragen, einen stationären Spannungspegel des Detektionssignals 646 zu bestimmen (zusammen mit dem optionalen resistiven Element 671 ($R_E$), das parallel zu dem ersten kapazitiven Element 670 ($C_1$) gekoppelt ist). Die zusätzlichen optionalen resistiven Elemente 688 ($R_{E1}$) und 671 ($R_E$) können auch dazu beitragen, einen stationären Spannungspegel am Knoten zwischen dem weiteren kapazitiven Element 686 (Cc), und den optionalen resistiven Elemente 688 ($R_{E1}$) und 671 ($R_E$) zu bestimmen. Damit können stationäre Überspannungen der kapazitiven Elemente 670, 674 ($C_1$, $C_2$) und dem weiteren kapazitiven Element 686 (Cc) vermieden werden. Beispielsweise kann der Isolationswiderstand der kapazitiven Elemente 670, 674 ($C_1$, $C_2$) und dem weiteren kapazitiven Element 686 (Cc) selbst für zwei Komponenten mit identischer Spezifikation deutlich unterschiedlich sein. Somit kann auch die über diesen Komponenten abfallende Spannung im stationären Zustand von Schaltung zu Schaltung variieren. Das kann zur Folge haben, dass im stationären Fall die Spannung über einem der kapazitiven Elemente 670, 674 ($C_1$, $C_2$) und dem weiteren kapazitiven Element 686 (Cc) eine zulässige Spannung überschreitet. Zudem kann der Isolationswiderstand der kapazitiven Elemente 670, 674 ($C_1$, $C_2$) und dem weiteren kapazitiven Element 686 (Cc) sich auch mit der Zeit verändern, so dass ebenfalls zu hohe Spannungen über einzelnen kapazitiven Elementen auftreten können.

Alternativ zu den optionalen resistiven Elemente 688 ($R_{E1}$) und 671 ($R_E$) kann in der Vorrichtung zur Detektion eines Verlaufs einer Kollektor-Emitter-Spannung eines Leistungshalbleiterschalters 642 auch ein resistives Element parallel zu dem weiteren kapazitiven Element 686 (Cc) geschaltet werden. Dieses resistive Element kann mindestens fünf- bis zehnmal so groß sein wie das erste resistive Element 672 ($R_1$).

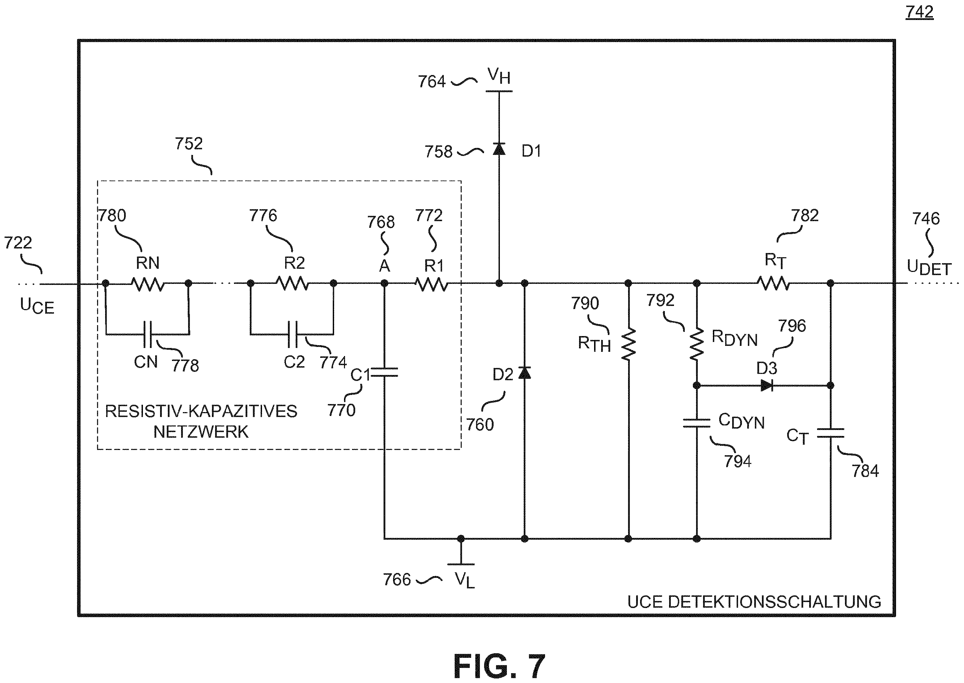

Die Vorrichtung zur Detektion eines Verlaufs einer Spannung über einem Leistungshalbleiterschalter 742 gemäß Fig. 7 weist alle Komponenten der Vorrichtung zur Detektion eines Verlaufs einer Spannung über einem Leistungshalbleiterschalter 442 gemäß Fig. 4 auf außer das optionale resistive Element 471 ($R_E$). Zudem enthält die Schaltung gemäß **Fig. 7** ein weiteres resistives Element 790 ($R_{th}$), das zwischen den Eingang der Zeitgeberschaltung und eine untere Referenzspannung 766 gekoppelt ist. Wie das optionale erste resistive Element ($R_E$) in den Vorrichtungen der **Fig. 4** oder **Fig. 6** dient das weiteres resistives Element 790 ($R_{th}$) dazu, einen Pegel des Detektionssignals 746 (mindestens teilweise) zu bestimmen. Wenn der Spannungspegel der Kollektor-Emitter-Spannung ($U_{CE}$) einige Zeit nach einem Umschaltvorgang ungefähr stationär ist, wird die Spannung am zweiten Knoten A 768 durch die resistiven Elemente des resistiv-kapazitiven Spannungsteilers 752 zumindest teilweise bestimmt. Dann kann das optionale weitere resistive Element 790 ($R_{th}$) dazu beitragen, den Spannungspegel am dritten Knoten des resistiv-kapazitiven Netzwerks 752 zu bestimmen. Der Spannungspegel am dritten Knoten bestimmt, bis auf welchen Wert eine Kapazität der Zeitgeberschaltung 762 in einem Normallfall und einem Kurzschluss- oder Überstromfall geladen oder entladen wird und so den stationären Pegel des Detektionssignals 746. Das optionale weitere resistive Element 790 ($R_{th}$) kann also dafür ausgewählt werden, um den stationären Pegel des Detektionssignals 746 festzulegen.

Unabhängig davon weist die Zeitgeberschaltung der **Fig. 7** ein zweites weiteres resistives Element 792 (R$_{DYN}$), eine zweite Kapazität 794 (C$_{DYN}$) und eine Diode 796 (D$_3$) auf, die dazu ausgelegt sind, einen dynamischen Pegel des Detektionssignals 746 zu beeinflussen. Dies kann nützlich sein um Hochvolt-IGBTs einschalten zu können, ohne dass die stationäre Detektionsschwelle massiv erhöht werden muss. Bei manchen Hochvolt-IGBTs dauert es mehrere 10 µs, bis eine stationäre Spannung im AN-Zustand erreicht wird.

Die obige Beschreibung der dargestellten Beispiele der vorliegenden Erfindung, ist nicht erschöpfend oder beschränkt auf die Beispiele gemeint. Während spezifische Ausführungsformen und Beispiele für die Erfindung hierin zu Veranschaulichungszwecken beschrieben sind, sind verschiedene Modifikationen möglich, ohne von der vorliegenden Erfindung abzuweichen. Die spezifischen Beispiele für Spannung, Strom, Frequenz, Leistung, Bereichswerte, Zeiten etc., sind nur illustrativ, so dass die vorliegende Erfindung auch mit anderen Werten für diese Größen umgesetzt werden kann.

Diese Modifikationen können an Beispielen der Erfindung im Lichte der obigen detaillierten Beschreibung durchgeführt werden. Die Begriffe, die in den folgenden Ansprüchen verwendet werden, sollten nicht so ausgelegt werden, als dass die Erfindung auf die spezifischen Ausführungsformen, die in der Beschreibung und den Ansprüchen offenbart sind, beschränkt ist. Die vorliegende Beschreibung und die Figuren sind als veranschaulichend und nicht als einschränkend anzusehen.

## Patentansprüche

1.  Vorrichtung zur Detektion eines Verlaufs einer Spannung über einem Leistungshalbleiterschalter, wobei die Vorrichtung umfasst:

    ein resistiv-kapazitives Netzwerk (352; 452) mit einem ersten, zweiten, dritten und vierten Knoten,
    wobei das resistiv-kapazitive Netzwerk (352; 452) dazu ausgelegt ist, an dem ersten Knoten mit einem Kollektor-, Anoden- oder Drain-Anschluss eines Leistungshalbleiterschalters verbunden zu werden und an dem zweiten Knoten (368; 468) ein Signal bereitzustellen, das für die Spannung über dem Leistungshalbleiterschalter repräsentativ ist,
    wobei das resistiv-kapazitive Netzwerk (352; 452) mindestens eine Impedanz (355; 356; 455; 456), die zwischen den ersten und den zweiten Knoten (368; 468) gekoppelt ist, ein erstes resistives Element (372; 472), das zwischen den zweiten Knoten (368; 468) und den dritten Knoten gekoppelt ist und ein erstes kapazitives Element (370; 470), das zwischen den zweiten Knoten (368; 468) und den vierten Knoten gekoppelt ist, wobei der vierte Knoten auf ein vorbestimmtes Referenzpotential gelegt ist, umfasst,

    wobei die Vorrichtung zur Detektion eines Verlaufs einer Spannung über dem Leistungshalbleiterschalter weiter umfasst:

    eine Zeitgeber-Schaltung (362; 462), die mit dem dritten Knoten des resistiv-kapazitiven Netzwerks (352; 452) verbunden ist und dazu ausgelegt ist, ein Detektionssignal (346; 446) zu erzeugen, das für einen Verlauf der Spannung über dem Leistungshalbleiterschalter (322; 422) nach einem Anschalten des Leistungshalbleiterschalters repräsentativ ist,
    wobei die Zeitgeber-Schaltung (362; 462) eine Kapazität (484) umfasst, die dazu ausgelegt ist, durch eine Spannung an dem dritten Knoten geladen zu werden und damit einen Pegel des Detektionssignals (346; 446) über eine vorbestimmte Schwellspannung zu heben, falls die Spannung über dem Leistungshalbleiterschalter (322; 422) nach Anschalten des Leistungshalbleiterschalters nicht unter einen vorbestimmten Wert fällt, und
    wobei das resistiv-kapazitive Netzwerk (352; 462) so ausgelegt ist, dass parasitäre Kapazitäten der Vorrichtung zur Detektion eines Verlaufs einer Spannung über dem Leistungshalbleiterschalter kompensiert oder überkompensiert werden, um zu verhindern, dass die Zeitgeberschaltung (362; 462) einen Pegel des Detektionssignals (346; 446) über die vorbestimmte Schwellspannung hebt, obwohl die Spannung über dem Leistungshalbleiterschalter nach Anschalten des Leistungshalbleiterschalters unter den vorbestimmten Wert fällt, **dadurch gekennzeichnet, dass** die Vorrichtung weiter eine Klemmschaltung (358; 458) umfasst, die dazu ausgelegt ist, eine Spannung am dritten Knoten des resistiv-kapazitiven Netzwerks (352; 452) auf eine vorbestimmte Maximalspannung (364; 464) zu begrenzen.

2.  Vorrichtung gemäß Anspruch 1, wobei die mindestens eine Impedanz (355; 356; 476; 480) die parasitären Kapazitäten der Vorrichtung zur Detektion eines Verlaufs einer Spannung über den Leistungshalbleiterschalter kompensiert oder überkompensiert.

3.  Vorrichtung gemäß einem der Ansprüche 1 bis 2, wobei das resistiv-kapazitive Netzwerk (352; 452) eine oder mehr weitere Impedanzen (355; 356; 455; 456) umfasst, die in Serie mit der mindestens einen Impedanz (355; 356; 455; 456) zwischen dem ersten Knoten und dem zweiten Knoten des resistiv-kapazitiven Netzwerks (352; 452) gekoppelt sind, und wobei die mindestens eine Impedanz und jede der ein oder mehr weiteren Impedanzen ein kapazitives (474; 478) und ein dazu paralleles resistives Element (476; 480) umfassen.

4. Vorrichtung gemäß einem der Ansprüche 1 bis 3, die weiter eine zweite Klemmschaltung (360; 460) enthält, die dazu ausgelegt ist, den dritten Knoten auf eine vorbestimmte Minimalspannung (366; 466) zu begrenzen.

5. Vorrichtung gemäß Anspruch 4, wobei die vorbestimmte Minimalspannung (366; 466) einem AUS-Pegel ($V_L$) eines Gate-Treibersignals des Leistungshalbleiterschalters entspricht und wobei die vorbestimmte Maximalspannung (364; 464) einem AN-Pegel ($V_H$) eines Gate-Treibersignals des Leistungshalbleiterschalters entspricht.

6. Vorrichtung gemäß einem der vorangehenden Ansprüche, wobei das resistiv-kapazitive Netzwerk (652) ein weiteres kapazitives Element (686) umfasst, das zwischen den zweiten Knoten (668) und das erste kapazitive Element (670) gekoppelt ist, wobei das weiteres kapazitives Element (686) zudem zwischen einen Anschluss eines kapazitiven (674) und einen Anschluss eines resistiven (676) Elements der mindestens einen Impedanz (656) eingefügt ist, wobei der Anschluss des resistiven Elements (676) zudem an den zweiten Knoten (668) gekoppelt ist und der Anschluss das kapazitiven Elements (674) der mindestens einen Impedanz (676) zudem an das erste kapazitive Element (670) gekoppelt ist und wobei die zweiten Anschlüsse des kapazitiven (674) und resistiven (676) Elements verbunden sind.

7. Vorrichtung gemäß Anspruch 6, wobei das erste kapazitive Element (670) einen mindestens fünfmal größeren Wert hat als das weitere kapazitive Element (686).

8. Vorrichtung gemäß Anspruch 3 und 6 oder 7, wobei das resistiv-kapazitive Netzwerk (652) ein erstes weiteres resistives Element (671) umfasst, das parallel zu dem ersten kapazitiven Element (670) geschaltet ist und ein weiteres resistives Element (688), das parallel zu einem zweiten kapazitiven Element (674) der mindestens einen Impedanz (674) oder der einen oder mehr weiteren Impedanzen (655) des resistiv-kapazitive Netzwerks (652) geschaltet ist

9. Vorrichtung gemäß Anspruch 8, wobei das erste und zweite weitere resistive Element (671; 688) dazu ausgelegt sind, eine Spannung über dem ersten und zweiten kapazitiven Element (670; 674; 678) zu begrenzen.

10. Vorrichtung gemäß einem der vorangehenden Ansprüche, wobei die Vorrichtung ein weiteres resistives Element (790) umfasst, das zwischen den dritten Knoten und ein Referenzpotential (766) gekoppelt ist und dazu ausgelegt ist, einen Pegel des Detektionssignals (746) mindestens teilweise einzustellen.

11. Vorrichtung gemäß einem der vorangehenden Ansprüche, wobei die Zeitgeberschaltung ein zweites weiteres resistives Element (792), eine zweite Kapazität (794) und eine Diode (796) umfasst, wobei das zweite weitere resistive Element (792) und die zweite Kapazität (794) zwischen den dritten Knoten und das vorbestimmtes Referenzpotential geschaltet sind und wobei die Diode (796) zwischen einen Mittelpunkt des zweiten weiteren resistiven Elements (792) und der zweiten Kapazität (794) und der Kapazität (794) geschaltet sind.

12. Vorrichtung zur Detektion eines Kurzschluss- oder Überstromzustands in einem Leistungshalbleiterschalter, wobei die Vorrichtung umfasst:

    eine Vorrichtung zur Detektion eines Verlaufs einer Spannung über einem Leistungshalbleiterschalter (242) gemäß einem der Ansprüche 1 bis 11; und
    einen Komparator (244), der das Detektionssignal (246) der Vorrichtung zur Detektion einer Spannung über einem Leistungshalbleiterschalter (242) und ein Referenzsignal (248) empfängt und einen Fehlersignal (250) ausgibt, das anzeigt, wenn das Detektionssignal (246) das Referenzsignal (248) übersteigt.

13. Steuerschaltung (118; 120) für einen Leistungshalbleiterschalter, wobei die Steuerschaltung umfasst:

    eine Vorrichtung zur Detektion eines Kurzschluss- oder Überstromzustands in einem Leistungshalbleiterschalters (242) gemäß Anspruch 12;
    eine Treiberschaltung (236), die das Fehlersignal (250) empfängt und einen Leistungshalbleiterschalter ausschaltet oder ein weiteres Fehlersignal für eine Systemsteuerung bereitstellt, falls das Detektionssignal das Referenzsignal übersteigt, und
    einen Leistungshalbleiterschalter (104; 106), der von der Steuerschaltung gesteuert wird.

**Claims**

1. A device for detecting a change in a voltage across a power semiconductor switch, the device comprising:

a resistive-capacitive network (352; 452) having a first, second, third, and fourth node,

wherein the resistive-capacitive network (352; 452) is designed to be connected to a collector terminal, anode terminal, or drain terminal of a power semiconductor switch at the first node, and to provide at the second node (368; 468) a signal that is representative of the voltage across the power semiconductor switch,

wherein the resistive-capacitive network (352; 452) includes at least one impedance (355; 356; 455; 456) that is coupled between the first and second nodes (368; 468), a first resistive element (372; 472) that is coupled between the second node (368; 468) and the third node, and a first capacitive element (370; 470) that is coupled between the second node (368; 468) and the fourth node, wherein the fourth node is at a predetermined reference potential,

the device for detecting a change in a voltage across the power semiconductor switch further comprising:

a timer circuit (362; 462) that is connected to the third node of the resistive-capacitive network (352; 452) and that is designed to generate a detection signal (346; 446) that is representative of a change in the voltage across the power semiconductor switch (322; 422) after the power semiconductor switch is switched on,

wherein the timer circuit (362; 462) includes a capacitor (484) that is designed to be charged by a voltage at the third node, and thus to raise a level of the detection signal (346; 446) above a predetermined threshold voltage if the voltage across the power semiconductor switch (322; 422) does not fall below a predetermined value after the power semiconductor switch is switched on, and

wherein the resistive-capacitive network (352; 462) is designed in such a way that parasitic capacitors of the device for detecting a change in a voltage across the power semiconductor switch are compensated or overcompensated for to prevent the timer circuit (362; 462) from raising a level of the detection signal (346; 446) above the predetermined threshold voltage, even though the voltage across the power semiconductor switch falls below the predetermined value after the power semiconductor switch is switched on,

**characterized in that** the device further comprises a clamping circuit (358; 458) that is designed to limit a voltage at the third node of the resistive-capacitive network (352; 452) to a predetermined maximum voltage (364; 464).

2. The device according to Claim 1, wherein the at least one impedance (355; 356; 476; 480) compensates or overcompensates for the parasitic capacitances of the device for detecting a change in a voltage across the power semiconductor switch.

3. The device according to one of Claims 1 to 2, wherein the resistive-capacitive network (352; 452) includes one or more further impedances (355; 356; 455; 456) coupled in series with the at least one impedance (355; 356; 455; 456) between the first node and the second node of the resistive-capacitive network (352; 452), and wherein the at least one impedance and each of the one or more further impedances include a capacitive element (474; 478) and a resistive element (476; 480) parallel thereto.

4. The device according to one of Claims 1 to 3, additionally containing a second clamping circuit (360; 460) that is designed to limit the third node to a predetermined minimum voltage (366; 466).

5. The device according to Claim 4, wherein the predetermined minimum voltage (366; 466) corresponds to an OFF level ($V_L$) of a gate driving signal of the power semiconductor switch, and wherein the predetermined maximum voltage (364; 464) corresponds to an ON level ($V_H$) of a gate driving signal of the power semiconductor switch.

6. The device according to one of the preceding claims, wherein the resistive-capacitive network (652) includes a further capacitive element (686) that is coupled between the second node (668) and the first capacitive element (670), wherein the further capacitive element (686) is additionally inserted between a terminal of a capacitive element (674) and a terminal of a resistive element (676) of the at least one impedance (656), wherein the terminal of the resistive element (676) is additionally coupled to the second node (668), and the terminal of the capacitive element (674) of the at least one impedance (676) is additionally coupled to the first capacitive element (670), and wherein the second terminals of the capacitive element (674) and the resistive element (676) are connected.

7. The device according to Claim 6, wherein the first capacitive element (670) is at least five times greater than the further capacitive element (686).

8. The device according to Claim 3 and 6 or 7, wherein the resistive-capacitive network (652) includes a first further resistive element (671) that is connected in parallel to the first capacitive element (670) and a further resistive element (688) that is connected in parallel to a second capacitive element (674) of the at least one impedance (674) or the one or more further impedances (655) of the resistive-capacitive network (652).

9. The device according to Claim 8, wherein the first and second further resistive elements (671; 688) are designed to limit a voltage across the first and second capacitive elements 670; 674; 678).

10. The device according to one of the preceding claims, wherein the device includes a further resistive element (790) that is coupled between the third node and a reference potential (766), and is designed to at least partially set a level of the detection signal (746).

11. The device according to one of the preceding claims, wherein the timer circuit includes a second further resistive element (792), a second capacitor (794), and a diode (796), wherein the second further resistive element (792) and the second capacitor (794) are connected between the third node and the predetermined reference potential, and wherein the diode (796) is connected between a midpoint of the second further resistive element (792) and the second capacitor (794), and the capacitor (794).

12. A device for detecting a short circuit or overcurrent state in a power semiconductor switch, the device comprising:

a device for detecting a change in a voltage across a power semiconductor switch (242) according to one of Claims 1 to 11; and a comparator (244) that receives the detection signal (246) of the device for detecting a voltage across a power semiconductor switch (242) and a reference signal (248), and outputs an error signal (250) that indicates if the detection signal (246) exceeds the reference signal (248).

13. A control circuit (118; 120) for a power semiconductor switch, the control circuit comprising:

a device for detecting a short circuit or overcurrent state in a power semiconductor switch (242) according to Claim 12; a driver circuit (236) that receives the error signal (250) and switches off a power semiconductor switch or provides a further error signal for a system control if the detection signal exceeds the reference signal, and a power semiconductor switch (104; 106) that is controlled by the control circuit.

## Revendications

1. Dispositif permettant de détecter l'évolution d'une tension au niveau d'un commutateur à semi-conducteur de puissance, le dispositif comprenant :

un réseau résistif-capacitif (352 ; 452) avec des premier, deuxième, troisième et quatrième noeuds,
le réseau résistif-capacitif (352 ; 452) étant conçu pour être connecté au premier noeud à une borne de collecteur, d'anode ou de drain d'un commutateur à semi-conducteur de puissance et pour fournir au deuxième noeud (368 ; 468) un signal représentant la tension au niveau du commutateur à semi-conducteur de puissance, le réseau résistif-capacitif (352 ; 452) comprenant au moins une impédance (355 ; 356 ; 455 ; 456) couplée entre les premier et deuxième noeuds (368 ; 468), un premier élément résistif (372 ; 472) couplé entre les deuxièmes noeuds (368 ; 468) et les troisièmes noeuds et un premier élément capacitif (370 ; 470) couplé entre les deuxièmes noeuds (368 ; 468) et les quatrièmes noeuds, le quatrième noeud étant placé sur un potentiel de référence prédéterminé, ledit dispositif permettant de détecter l'évolution d'une tension au niveau du commutateur à semi-conducteur de puissance comprenant en outre :

un circuit de temporisation (362 ; 462) relié au troisième noeud du réseau résistif-capacitif (352 ; 452) et conçu pour générer un signal de détection (346 ; 446) représentant l'évolution de la tension au niveau du commutateur à semi-conducteur de puissance (322 ; 422) après une mise sous tension du commutateur à semi-conducteur de puissance,
le circuit de temporisation (362 ; 462) comprenant une capacité (484) conçue pour être chargée par une tension au troisième noeud et donc pour élever un niveau du signal de détection (346 ; 446) au-dessus d'une tension de seuil prédéterminée si la tension au niveau du commutateur à semi-conducteur de puissance (322 ; 422) ne descend pas au-dessous d'une valeur prédéterminée après la mise sous tension du commutateur à semi-conducteur de puissance, et
le réseau résistif-capacitif (352 ; 462) étant conçu de telle sorte que des capacités parasites du dispositif permettant de détecter l'évolution d'une tension au niveau du commutateur à semi-conducteur de puissance sont compensées ou surcompensées afin d'empêcher que le circuit de temporisation (362 ; 462) n'élève le niveau du signal de détection (346 ; 446) au-dessus de la tension de seuil prédéterminée bien que la tension au niveau du commutateur à semi-conducteur de puissance après la mise sous tension du commutateur à semi-conducteur de puissance descende sous la valeur prédéterminée,

**caractérisé en ce que** le dispositif comprend en outre un circuit de blocage (358 ; 458) conçu pour limiter une tension au troisième noeud du réseau résistif-capacitif (352 ; 452) à une tension maximale prédéterminée (364 ; 464).

2. Dispositif selon la revendication 1, dans lequel ladite au moins une impédance (355 ; 356 ; 476 ; 480) compense ou surcompense les capacités parasites du dispositif permettant de détecter l'évolution d'une tension au niveau du commutateur à semi-conducteur de puissance.

3. Dispositif selon l'une quelconque des revendications 1 à 2, dans lequel le réseau résistif-capacitif (352 ; 452) comprend une ou plusieurs impédances supplémentaires (355 ; 356 ; 455 ; 456) connectées en série avec ladite au moins une impédance (355 ; 356 ; 455 ; 456) entre le premier noeud et le deuxième noeud du réseau résistif-capacitif (352 ; 452), et dans lequel ladite au moins une impédance et chacune de ladite une ou desdites plusieurs impédances comprennent un élément capacitif (474 ; 478) et un élément résistif (476 ; 480) parallèle à celui-ci.

4. Dispositif selon l'une quelconque des revendications 1 à 3, comprenant en outre un deuxième circuit de blocage (360 ; 460) conçu pour limiter le troisième noeud à une tension minimale prédéterminée (366 ; 466).

5. Dispositif selon la revendication 4, dans lequel la tension minimale prédéterminée (366 ; 466) correspond à un niveau ARRET ($V_L$) d'un signal de commande de grille du commutateur à semi-conducteur de puissance, et la tension maximale prédéterminée (364 ; 464) correspond à un niveau MARCHE ($V_H$) d'un signal de commande de grille du commutateur à semi-conducteur de puissance.

6. Dispositif selon l'une quelconque des revendications précédentes, dans lequel le réseau résistif-capacitif (652) comprend un élément capacitif supplémentaire (686) couplé entre le deuxième noeud (668) et le premier élément capacitif (670), dans lequel l'élément capacitif supplémentaire (686) est en outre inséré entre une borne d'un élément capacitif (674) et une borne d'un élément résistif (676) de ladite au moins une impédance (656), dans lequel la borne de l'élément résistif (676) est en outre couplée au deuxième noeud (668) et la borne de l'élément capacitif (674) de ladite au moins une impédance (676) est de plus couplée au premier élément capacitif (670), et dans lequel les deuxièmes bornes de l'élément capacitif (674) et de l'élément résistif (676) sont reliées.

7. Dispositif selon la revendication 6, dans lequel le premier élément capacitif (670) présente une valeur cinq fois supérieure à celle de l'élément capacitif supplémentaire (686).

8. Dispositif selon les revendications 3 et 6 ou 7, dans lequel le réseau résistif-capacitif (652) comprend un premier élément résistif supplémentaire (671) connecté en parallèle au premier élément capacitif (670) et un élément résistif supplémentaire (688) connecté en parallèle à un deuxième élément capacitif (674) de ladite au moins une impédance (674) ou de ladite une ou desdites plusieurs impédances supplémentaires (655) du réseau résistif-capacitif (652).

9. Dispositif selon la revendication 8, dans lequel les premier et deuxième éléments résistifs supplémentaires (671 ; 688) sont conçus pour limiter une tension au niveau des premier et deuxième éléments capacitifs (670 ; 674 ; 678).

10. Dispositif selon l'une quelconque des revendications précédentes, dans lequel le dispositif comprend un élément résistif supplémentaire (790) couplé entre le troisième noeud et un potentiel de référence (766) et conçu pour régler au moins en partie un niveau du signal de détection (746).

11. Dispositif selon l'une quelconque des revendications précédentes, dans lequel le circuit de temporisation comprend un deuxième élément résistif supplémentaire (792), une deuxième capacité (794) et une diode (796), dans lequel le deuxième élément résistif supplémentaire (792) et la deuxième capacité (794) sont connectés entre le troisième noeud et le potentiel de référence prédéterminé, et dans lequel la diode (796) est connectée entre un point milieu du deuxième élément résistif supplémentaire (792) et de la deuxième capacité (794) et la capacité (794).

12. Dispositif permettant de détecter un état de court-circuit ou de surintensité dans un commutateur à semi-conducteur de puissance, le dispositif comprenant :

un dispositif permettant de détecter l'évolution d'une tension au niveau d'un commutateur à semi-conducteur de puissance (242) selon l'une quelconque des revendications 1 à 11 ; et
un comparateur (244) recevant le signal de détection (246) du dispositif permettant de détecter l'évolution d'une tension au niveau d'un commutateur à semi-conducteur de puissance (242) et un signal de référence (248) et délivrant un signal d'erreur (250) indiquant si le signal de détection (246) dépasse le signal de référence (248).

13. Circuit de commande (118 ; 120) pour un commutateur à semi-conducteur de puissance, le circuit de commande comprenant :

un dispositif permettant de détecter un état de court-circuit ou de surintensité dans un commutateur à semi-conducteur de puissance (242) selon la revendication 12 ;
un circuit d'attaque (236) recevant le signal d'erreur (250) et mettant hors tension un commutateur à semi-conducteur de puissance ou fournissant un signal d'erreur supplémentaire pour une commande système au cas où le signal de détection dépasserait le signal de référence, et un commutateur à semi-conducteur de puissance (104 ; 106) commandé par le circuit de commande.

**FIG. 1A**

FIG. 1B

**FIG. 2**

**FIG. 3**

EP 2 884 662 B1

**FIG. 4**

EP 2 884 662 B1

FIG. 5

**FIG. 6**

**FIG. 7**

**EP 2 884 662 B1**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

*   EP 2501042 A1